# FASCICULE DE BREVET EUROPEEN

(11) **EP 3 061 692 B1**
(45) Date de publication et mention de la délivrance du brevet: **04.04.2018**
(21) Numéro de dépôt: 15156365.7
(22) Date de dépôt: 24.02.2015
(51) Int. Cl.: B64G 99/00, G06F 17/50, B64G 1/00

(54) **MÉTHODE POUR RÉPARTIR À L'AIDE D'UN ORGANE UN FLUX D'UNE CONTRAINTE TRANSMISE ENTRE UNE PREMIÈRE PARTIE COMPOSANTE ET UNE DEUXIÈME PARTIE COMPOSANTE À ASSEMBLER**
METHODE ZUM VERTEILEN EINES ÜBERTRAGENEN SPANNUNGSFLUSSES MITHILFE EINES ORGANS ZWISCHEN EINEM ERSTEN BESTANDTEIL UND EINEM ZWEITEN BESTANDTEIL, DIE ZUSAMMENZUBAUEN SIND
METHOD FOR DISTRIBUTING, BY MEANS OF A MEMBER, A FLUX OF A STRAIN TRANSMITTED BETWEEN A FIRST COMPONENT PORTION AND A SECOND COMPONENT PORTION TO BE ASSEMBLED

(43) Date de publication de la demande: 31.08.2016
(73) Titulaire: Sociéte Anonyme Belge de Constructions Aéronautiques, S.A.B.C.A., 1130 Bruxelles (BE)
(72) Inventeur: Demuysere, Pierre, 1130 Bruxelles (BE)
(74) Mandataire: Quintelier, Claude

(56) Documents cités:
- CN-A- 103 150 486
- DE-A1-102005 060 557
- US-A1- 2008 164 372

## Description

La présente invention concerne une méthode pour répartir un flux d'une contrainte transmise entre une première partie composante et une deuxième partie composante à assembler, la première et la deuxième partie composante ayant chacune des caractéristiques de raideur prédéterminées,

Nombreux sont les domaines dans lesquels la répartition des flux de contraintes mécaniques dans une structure formée par des parties composantes ou des flux transmis d'une pièce composante à une autre ont une importance telle qu'elle justifie une étude spécifique et/ou une adaptation des pièces ou parties concernées. Les objectifs de la répartition des flux sont divers et, se résument souvent au besoin de limiter les contraintes dans la ou les parties concernées. Ce besoin de réduire les contraintes locales se rencontre de plus en plus fréquemment, en particulier dans les parties composantes comprenant des matériaux composites très peu tolérants aux concentrations de contraintes.

Les techniques actuellement utilisées pour maîtriser ou répartir les contraintes locales sont essentiellement le travail sur l'architecture générale des structures, l'étude sur leur configuration géométrique, une répartition étudiée de leurs épaisseurs ou raideurs, ou encore l'ajout de pièces ou parties structurales.

Par exemple, dans le lanceur civil Ariane 4 de l'Agence Spatiale Européenne (ESA) et qui fait partie de la famille des lanceurs européens Ariane, aux moins deux propulseurs latéraux sont accrochés au segment inférieur du lanceur. Ces propulseurs sont composés de deux réservoirs joints par une jupe inter-réservoir, d'une jupe arrière et d'une jupe avant. Entre le réservoir arrière et la jupe arrière se situe l'interface jupe/réservoir arrière. L'accrochage de ces propulseurs sur le segment inférieur du lanceur est réalisé par un dispositif d'accrochage localisé sur la jupe arrière des propulseurs latéraux. Pour éviter l'endommagement du réservoir arrière, il a été nécessaire de répartir les flux de contraintes transitant par l'interface jupe/réservoir arrière. La solution technique considérée a été de donner à la partie de la jupe qui relie le dispositif d'accrochage à l'interface jupe/réservoir arrière une épaisseur variable. Malheureusement, cette solution a augmenté sensiblement la complexité de production de la structure de la jupe arrière.

Dans le cas de l'accrochage des propulseurs d'appoint de l'Atlas V, lanceur américain développé à la fin des années 1990, des ferrures spécifiques en forme de V ont été nécessaires. Cette solution technique a alourdit et compliqué la structure du premier étage du lanceur.

La demande de brevet DE 10 2005 060 557 décrit un procédé de calcul permettant de prendre en compte l'effet de l'endommagement dans la modélisation d'une liaison entre deux pièces de construction. En faisant usage d'un maillage et d'une charge on procède à une simulation par éléments finis. On calcule une tension produite dans un élément de volume et l'on vérifie si la liaison résiste à la tension.

La demande de brevet CN 103 150 486 décrit une méthode pour déterminer un facteur de réduction d'une capacité de charge d'une structure en coque soumise à une compression axiale. A cette fin on introduit des imperfections dans une coque parfaitement cylindrique pour évaluer le comportement en stabilité de la structure.

Le fait de proposer des structures plus complexes rend difficile la construction de telles structures augmentant ainsi leur coût de production. Le fait de les alourdir en réduit la performance. Cette augmentation de complexité et de masse accompagne généralement le recours aux solutions connues, qui imposent en général d'intervenir directement sur au moins une des parties composantes, ce qui entraîne très souvent des problèmes sur cette partie composante.

L'invention a pour but de pallier les inconvénients susdits en procurant une méthode permettant d'atteindre une répartition prédéterminée d'un flux de contraintes en fonction de la finalité de l'assemblage à réaliser sans compliquer ni alourdir les pièces ou parties composantes formant un tel assemblage et sans devoir sensiblement modifier la géométrie des parties composantes. Elle permet en outre d'améliorer le comportement mécanique desdites parties composantes en répartissant les contraintes locales et ainsi d'améliorer les marges de sécurité de telles parties ou de donner la possibilité d'en réduire la masse.

A cette fin, la méthode pour répartir un flux d'une contrainte transmise entre une première partie composante et une deuxième partie composante à assembler suivant l'invention comprend les étapes de :
- choisir parmi la première et la deuxième partie composante une partie initiale correspondant à celle où une force prédéterminée et corrélée à la contrainte devra être appliquée et une partie réceptrice, qui est l'autre que celle choisie comme partie initiale ;
- modéliser la partie initiale et au moins une des caractéristiques de raideur de la partie réceptrice à l'aide d'une simulation numérique par éléments finis et déterminer ainsi un modèle numérique qui comprend la force et les conditions limites associées aux parties modélisées ;
- identifier une interface entre la partie initiale et la partie réceptrice , laquelle interface représente une surface de contact lorsque la partie initiale et la partie réceptrice sont en contact l'une avec l'autre ;
- déterminer dans soit la partie réceptrice, soit la partie initiale, soit la partie initiale et la partie réceptrice une zone critique où une modification du flux est recherchée;
- déterminer dans l'interface une zone de modification où un organe susceptible d'obtenir la modification du flux de contrainte dans la zone critique sera introduit et déterminer dans cette zone de modification une position d'origine au droit d'une position où la force induisant la contrainte sera appliquée;
- choisir, en fonction de la modification du flux à appliquer, l'organe parmi des types prédéterminés d'organes;
- déterminer dans le modèle numérique et en fonction de la modification du flux à appliquer, des variables associées au type d'organe déterminé, lesquelles variables définissent les propriétés permettant la modification du flux à appliquer ;
- déterminer pour chacune des variables associées au type d'organe déterminé une valeur initiale pour obtenir un ensemble de variables initiales;
- calculer, en faisant usage du modèle numérique, la valeur maximale initiale du flux de la contrainte dans la zone critique ;
- à partir de la valeur initiale des variables, modifier la valeur des variables associées au type d'organe déterminé pour obtenir une valeur subséquente des variables ;
- calculer, en utilisant la valeur subséquente des variables dans le modèle numérique, la valeur maximale subséquente du flux dans la zone critique;
- comparer la valeur maximale subséquente du flux à la valeur maximale initiale du flux dans la zone critique et sélectionner la plus petite des deux valeurs ;
- par itération, modifier la valeur subséquente des variables et calculer en utilisant chaque fois la valeur subséquente modifiée des variables ainsi déterminée la valeur maximale subséquente du flux dans la zone critique, et répéter à chaque fois la comparaison pour ainsi obtenir la plus petite valeur maximale du flux ;
- définir à partir de la valeur subséquente des variables ayant mené à la plus petite valeur maximale du flux l'organe modifiant le flux de contrainte dans la zone critique.

Modéliser la partie initiale et au moins une des caractéristiques de raideur de la partie réceptrice en utilisant des éléments finis permet de déterminer un modèle numérique et de calculer numériquement le comportement des parties composantes et leur assemblage, par exemple par des équations partielles linéaires. Ce modèle à base d'éléments finis permet donc d'analyser le comportement mécanique de l'assemblage à l'aide de graphiques présentant la transmission des contraintes et prenant en compte les conditions au niveau de l'interface entre chaque partie ainsi que celles à l'endroit où la force prédéterminée est appliquée. Cette modélisation utilise des codes de calculs pour que le modèle soit ainsi fidèle aux conditions réelles de l'assemblage et que le problème sous étude puisse être analysé en considérant tout l'ensemble sous les conditions réelles.

La détermination de la zone critique permet de modéliser le problème en identifiant la partie de l'assemblage qui souffre directement par l'application de la force prédéterminée et l'effet que ceci provoque dans l'ensemble vu de manière intégrale. En déterminant dans l'interface une zone de modification où un organe susceptible d'obtenir la modification du flux de la contrainte dans la zone critique peut être introduit, il devient possible d'introduire dans le modèle numérique un modèle de cet organe et la zone où il sera introduit, pour ainsi déterminer la configuration de cet organe. De plus l'organe est choisi parmi des types déterminés d'organes auquel est associé un type prédéterminé de variables permettant, en les modifiant, de faire varier la configuration de l'organe pour se rapprocher de la configuration voulue du flux. En partant d'une valeur initiale des variables associées au type d'organe et en faisant, par itération, varier cette valeur initiale il devient possible de trouver la combinaison de variables qui donne la plus petite valeur maximale du flux et ainsi d'en déduire la géométrie et le type d'organe. Cette détermination se fait soit par itérations successives en comparant les résultats des différentes itérations, soit par optimisation automatique lorsque le logiciel utilisé le permet, soit par pondération d'un profil particulier de jeu à l'interface. Le jeu étant un des types prédéterminés de variable associée à un type prédéterminé d'organe. En l'occurrence, il s'agit ici d'un petit écart entre les parties composantes destiné à être comblé lors de l'application de la charge.

Ainsi, l'organe peut être usiné selon les valeurs obtenues par le modèle et l'organe ainsi déterminé permet d'obtenir la meilleure répartition de flux de contrainte transmise. Ainsi, la méthode selon l'invention s'avère un moyen efficace pour modifier les flux en intervenant très peu sur les parties composantes assemblées. La modification de flux dans une structure unique peut se faire simplement par une séparation de la structure en deux parties composantes afin d'apporter l'organe entre les parties composantes.

La méthode peut être réalisée par l'actuelle capacité des codes de calculs de traiter des modifications dimensionnelles minimes (de l'ordre du centième de millimètre), et par l'utilisation de moyens de production contrôlés numériquement permettant d'obtenir la grande précision nécessaire à l'usinage de l'organe suivant les résultats obtenus pour la meilleure répartition du flux, c'est-à-dire celle qui a donné la plus petite valeur maximale du flux.

Lorsqu'on atteint l'objectif de réduire la valeur maximale du flux, c'est-à-dire la meilleur répartition du flux évitant l'effet des contraintes locales, on obtient une amélioration du comportement des structures vis-à-vis du flambement, ceci puisque l'on réduit le niveau de contrainte aux endroits les plus critiques.

Donc, la méthode développée constitue un moyen simple et peu coûteux pour modifier la distribution des flux dans les structures comprenant des parties composantes assemblées, et ainsi elle présente un outil qui permet l'optimisation en tenue et/ou en masse de ces structures. Ainsi, l'insertion d'un organe tel qu'obtenu par la méthode évite la complexification des parties composantes ou le recours à des structures additionnelles lourdes et coûteuses.

Le processus itératif de la méthode permet donc l'obtention d'un ensemble de configurations avec chacune une répartition de flux spécifique, procurant ainsi un moyen pour évaluer et analyser l'intérêt de ces différentes valeurs de flux répartis afin de choisir la meilleure répartition. Ceci par rapport aux critères préalablement établis comme par exemple, le coût de l'assemblage, le risque de rupture des parties composantes, la complexité de l'organe, les dimensions des parties composantes et de la structure assemblée, etc.

La condition de meilleure répartition du flux se détermine par une analyse au cas par cas, c'est-à-dire pour le cas traité en particulier, en prenant compte les paramètres et conditions de la première et deuxième partie composante à assembler.

Une première forme de réalisation préférentielle de la méthode suivant l'invention est caractérisée en ce que les types prédéterminés d'organe sont soit une cale, ou un ensemble de cales, d'épaisseur variable, soit une cale, ou un ensemble de cales, de raideur variable, soit des éléments d'assemblage de raideur variable. On couvre ainsi un large choix de types d'organes, qui de plus sont facile à interposer entre les parties composantes ou à utiliser pour leur assemblage.

Une deuxième forme de réalisation préférentielle de la méthode suivant l'invention est caractérisée en ce que les variables associées au type d'organe sont soit des caractéristiques de raideur, soit des caractéristiques de jeu, ou une fonction mathématique décrivant la répartition de ces caractéristiques. Par la raideur, par exemple formée par une cale de raideur variable ou éléments d'assemblage de raideur variable, il est possible d'agir soit sur la compression, soit sur la traction entre les parties composantes. Par le jeu, par exemple formé par une cale d'épaisseur variable, il est possible d'agir sur la compression.

De manière avantageuse, dans la méthode pour répartir un flux d'une contrainte transmise entre une première partie composante et une deuxième partie composante à assembler suivant l'invention, les variables associées à la représentation du jeu dans les modèles sont soit celles de jeux, soit des coefficient d'élasticité. Différents paramètres peuvent être pris en considération dans le modèle, selon l'assemblage sous étude, et ces paramètres peuvent donc être représentés par différents effets sur la zone de modification.

Une troisième forme de réalisation préférentielle de la méthode suivant l'invention est caractérisée en ce que on modélise en définissant une première géométrie de la première partie composante et une deuxième géométrie de la deuxième partie composante à l'aide d'une simulation numérique par éléments finis, lesquels sont représentés par des éléments et des noeuds. Ceci donne la possibilité de modéliser des assemblages, même ceux ayant des structures complexes, d'une manière simple et d'utiliser des programmes informatiques connus. L'usage de noeuds permet de modéliser d'une manière simple les parties composantes et leurs bords, les conditions limites, et leurs zone de contact lorsqu'elles sont assemblées. Les noeuds de la partie initiale et de la réceptrice au niveau de l'interface sont de préférence positionnées en vis-à-vis l'un de l'autre formant des couples de noeuds entre lesquels peuvent être introduits soit des jeux représentant l'écart physique local entre les parties assemblées, lorsque l'organe interposé génère des jeux, soit des éléments représentant les caractéristiques locales de raideur, lorsque l'organe ajouté possède des caractéristiques de raideur variable.

Une quatrième forme de réalisation préférentielle de la méthode suivant l'invention est caractérisée en ce que l'organe est formé par des jeux, et en ce que la détermination de la valeur initiale des variables est réalisée en retirant au niveau de l'interface dans le modèle la liaison perpendiculaire entre les parties composantes, ensuite en calculant une déformation des parties composantes sous l'effet de la charge pour obtenir une courbe d'interpénétration entre la partie initiale et la partie réceptrice, la valeur initiale des jeux pour chaque couple de noeud dans la zone de modification étant déterminée à l'aide de ladite courbe d'interpénétration. On obtient ainsi la courbe d'interpénétration en ne reliant pas, dans la zone de l'interface où l'on compte introduire les jeux, les modèles des parties composantes. Ceci donne alors un profil de référence en relevant dans les résultats des calculs, l'interpénétration de ces modèles des parties composantes. La valeur initiale des variables du jeux peut alors être déterminée à partir de cette courbe d'interpénétration.

De préférence après avoir déterminé la valeur initiale on remet alors dans le modèle la liaison perpendiculaire entre les parties composantes, et on introduit l'organe dans le modèle en prenant cette valeur initiale pour déterminer ensuite la courbe de flux. Ceci permet de déterminer une courbe de flux en présence de l'organe. Avantageusement on fait alors varier le flux en multipliant le profil de référence obtenu par la valeur initiale des variables par une valeur variable de pondération allant de préférence de 0.0 à 1.0 par pas de 0.1. Pour chacune de ces pondérations, le modèle est calculé et la contrainte dans la zone critique analysée et comparée afin de trouver la pondération particulière qui permet une réduction prédéterminée du flux de la contrainte dans cette zone critique. Cette pondération particulière permet de déterminer le profil de jeu optimal. La pratique montre que dans la plupart des cas les itérations vont au plus jusqu'à six et que l'optimum, l'optimisation de la répartition de flux, est obtenu lorsque la valeur de pondération variable est proche de 0.8.

De préférence dans la méthode pour répartir un flux d'une contrainte transmise entre une première partie composante et une deuxième partie composante à assembler suivant l'invention, l'interface est une surface sensiblement perpendiculaire au flux de la contrainte transmise.

Suivant une forme de réalisation de l'invention dans la méthode pour répartir un flux d'une contrainte transmise entre une première partie composante et une deuxième partie composante à assembler, le jeu est représenté par un déplacement limité entre chaque couple de noeuds en vis-à-vis. Ces jeux sont disponibles dans plusieurs codes de calcul (NASTRAN (marque déposée) par exemple). Ces jeux permettent d'établir dans le modèle les conditions de distribution d'efforts ou de contraintes que les parties composantes subissent lorsqu'elles sont assemblées et soumises à l'application de la force critique. Ceci permet de modéliser les conditions réelles lorsque les parties sont physiquement assemblées. La modélisation des conditions réelles permet d'aboutir à une configuration des parties composantes à assembler ayant le comportement recherché, et ce, sans avoir à effectuer un usinage physique à chaque itération du processus d'essai/erreur.

Avantageusement, dans la méthode pour répartir un flux d'une contrainte transmise entre une première partie composante et une deuxième partie composante à assembler suivant l'invention, l'organe est formé par une pièce intercalaire, un ensemble de pièces intercalaires ou un ensemble d'éléments d'assemblage. Donc, l'organe est déterminé par rapport au problème traité et peut être formé par une ou plusieurs pièces selon les besoins.

Suivant une forme avantageuse de la méthode pour répartir un flux d'une contrainte transmise entre une première partie composante et une deuxième partie composante à assembler suivant l'invention, l'organe est formé d'une pièce, ou un ensemble de pièces, dont l'épaisseur est deux ordres de grandeur plus petite que la dimension des parties à assembler. Ainsi, dans un assemblage dans lequel les parties composantes ont une dimension en mètres, l'organe peut présenter une épaisseur typique, de 2 à 50, mais plus spécialement 5 à 20 millimètres. Ce qui montre qu'un organe très fin par rapport aux parties composantes peut être utilisé pour une répartition de flux optimale. Donc, un organe fin entre les parties composantes évite des changements dans les parties composantes elles-mêmes, c'est-à-dire de devoir modifier la géométrie des parties composantes, en les rendant plus lourdes et/ou plus complexes.

En particulier, selon une forme de réalisation particulière de la méthode pour répartir un flux d'une contrainte transmise entre une première partie composante et une deuxième partie composante à assembler suivant l'invention, l'organe présente une épaisseur ou une raideur qui varie sur la longueur de l'organe. Ainsi, l'organe peut consister en une ou plusieurs parties présentant différentes épaisseurs ou raideurs et peut s'adapter aux conditions prédéterminées selon le modèle et l'analyse réalisée. Par exemple, on peut combiner une couche d'aluminium et une couche d'élastomère. Si l'épaisseur de la couche d'aluminium varie, et que celle de la couche d'élastomère varie également, de sorte que la somme des deux épaisseurs est constante, on aura réalisé un organe dont la raideur est variable le long de sa dimension principale et dont l'épaisseur est constante. Ceci augment le choix des configurations disponibles pour déterminer et fabriquer l'organe en fonction des conditions de l'assemblage recherchées.

De préférence dans la méthode pour répartir un flux d'une contrainte transmise entre une première partie composante et une deuxième partie composante à assembler on détermine si la première partie composante et la deuxième partie composante doivent être assemblées par précontrainte, et si tel est le cas un ensemble de fixations appropriées est intégré entre la première partie composante et la deuxième partie composante. Ceci est réalisé selon les critères prédéterminés en fonction de l'assemblage à réaliser (tension dans les éléments de liaison, contraintes locales autour de ces éléments, risque de corrosion sous tension, risque de fluage,...) et d'acceptabilité du jeu (présence d'une ouverture entre les structures, déformation de la structure en service, déplacement du point d'application de la charge en service,...). En effet, dans de nombreux cas, et en particulier les assemblages boulonnés, il sera possible, en choisissant les vis de fixation et leur serrage, de combler le jeu formé par la pièce de distribution, et ainsi créer un champ de contrainte opposé à celui généré par la charge que l'on considère. Ceci permet d'éviter les discontinuités entre les structures et d'appliquer aux fixations des pré-tensions compatibles des bonnes pratiques. Il y a lieu, dans ce cas, de prendre en compte cette précontrainte dans la vérification et l'analyse des structures jointes et de leurs fixations.

En particulier dans la méthode pour répartir un flux d'une contrainte transmise entre une première partie composante et une deuxième partie composante à assembler, les éléments de fixation entre la première et la deuxième partie composante sont choisis avec soin en prenant en compte les caractéristiques de l'assemblage. Le cas échéant, le recours à des éléments permettant d'éviter des problèmes liés aux fixations sera nécessaire, tel que l'utilisation de rondelles Belleville (rondelles ressorts) ou autre éléments de maintien élastiques, ou le recours à des écrous auto-freinés.

L'invention sera maintenant décrite plus en détails à l'aide des dessins illustrant des formes de réalisation préférée de la méthode pour répartir un flux d'une contrainte transmise entre une première partie composante et une deuxième partie composante à assembler. Dans les dessins :
les figures 1 et 2 illustrent l'ensemble jupe/réservoir d'un propulseur latéral d'un lanceur spatial dont la jupe est soumise à une force F;
la figure 3 illustre une zone de modification à l'interface entre deux parties composantes ;
la figure 4 représente la modélisation à l'aide d'une simulation numérique par des éléments finis représentés par des lignes et des noeuds d'une première et d'une deuxième partie composante ;
la figure 5a illustre une répartition du flux de la contrainte dans une zone critique, sans dispositif de réduction de flux, et la figure 5b illustre trois différentes répartition du flux de la contrainte dans la zone critique après modification de l'interface, et la figure 5c illustre répartition du flux sans dispositif de réduction de flux comparée à une répartition théoriquement optimale du flux sur la zone critique;
la figure 6 illustre une courbe d'interpénétration des parties composantes selon la coordonnée curviligne de l'interface ;
la figure 7 montre suivant un mode de réalisation de l'invention lorsque la variable associée au type d'organe est un jeu, trois différentes courbes du flux de contrainte pour différentes répartitions de jeu, définies par une répartition initiale pondérée ;
la figure 8 illustre une courbe en continu montrant des valeurs de flux maximum par rapport à des valeurs de pondération allant de 0.5 à 1 lorsque la variable associée au type d'organe est un jeu ;
les figures 9 à 12 illustrent de manière schématique le flux de contrainte transitant entre deux structures cylindriques d'épaisseur uniforme, les structures de droite sur les figures présentent l'effet sur le flux d'un organe d'épaisseur variable, créant une distribution de jeux entre les parties composantes;
la figure 13 illustre l'interposition entre les parties composantes assemblées d'un organe ou d'un ensemble d'organes d'épaisseur variable ;
la figure 14 illustre un organe créé directement sur une des faces contigües des parties composantes assemblées ;
les figures 15 et 16 illustrent l'interposition entre les parties composantes assemblées d'un organe de raideur variable ;
la figure 17 illustre l'interposition entre une des parties composantes assemblées et les éléments de fixations d'un organe d'épaisseur variable, l'assemblage étant soumis à une force de traction ;
la figure 18 illustre l'interposition entre une des parties composantes assemblées des éléments de fixation étant des rondelles ressorts de raideurs et d'épaisseurs variable, l'assemblage étant soumis à une force de traction ;
la figure 19 illustre l'utilisation d'une rondelle ressort appelée rondelle Belleville pour éviter la perte de tension dans le fixations,
les figures 20 et 21 illustrent les contraintes longitudinales en fonction de la charge appliquée, respectivement sans et avec un organe ;
la figure 22 montre un organe interposé entre deux parties composantes réalisées physiquement ; et
la figure 23 montre l'effet sur le flux par l'application d'un jeu évoluant selon un profil sinusoïdal entre les deux parties de l'exemple de la figure 22.

Dans les dessins une même référence a été attribuée à un même élément ou à un élément analogue.

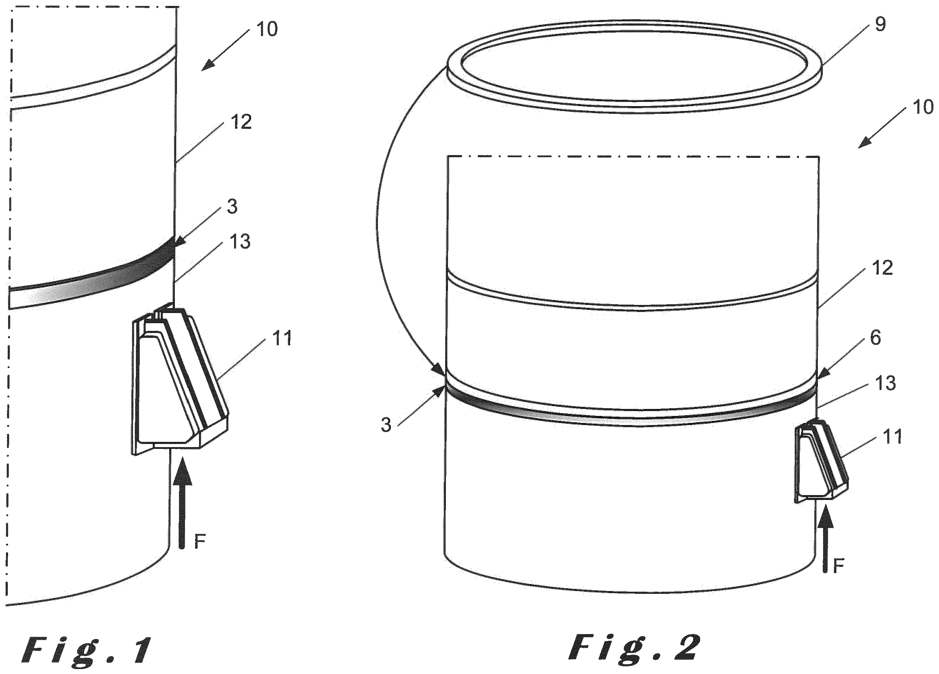

La présente invention concerne une méthode pour répartir un flux d'une contrainte transmise entre une première partie composante et une deuxième partie composante. Afin de définir le cadre de l'invention, nous l'illustrons par un exemple choisi dans un champ d'application directe de cette invention. Il s'agit de l'accrochage des propulseurs latéraux dans un lanceur spatial 10 dont une fraction est illustré aux figures 1 et 2. Ces dernières illustrent un ensemble d'une jupe 13 et d'un réservoir 12 du propulseur latéral 10 du lanceur spatial dont la jupe est soumise à une force F. Entre la jupe et le réservoir est interposé un organe 9, dans ce cas un anneau d'épaisseur variable, permettant de répartir le flux de contrainte imposée par la force F et transmise de la jupe au réservoir. Cet organe permet de réduire la valeur maximale de la contrainte imposée au réservoir. Dans la présente invention la valeur de la contrainte fait essentiellement référence à des flux d'efforts sur les interfaces reliant les deux parties composantes, à savoir la jupe et le réservoir, qui forment l'assemblage lui-même formé par le propulseur latéral 10. Cette valeur peut être en particulier celle du tenseur de contrainte décrivant les contraintes générées par la force F, tenseur projeté sur la normale à une interface 3 entre les deux parties composantes. Cette valeur peut également être un scalaire associé à ce tenseur. Donc, le flux d'une contrainte transmise entre une première partie composante, à savoir la jupe, et une deuxième partie composante, à savoir le réservoir, à assembler, constitue la quantité de force par unité de surface ou par unité de longueur selon la modélisation choisie.

Il faut noter que lors de l'étude des structures, le terme contrainte peut être formalisé mathématiquement de différentes manières. Un tenseur de contrainte est une représentation utilisée en mécanique des milieux continus pour caractériser l'état de contrainte, c'est-à-dire les efforts internes mis en jeu entre les parties déformées du milieu.

Dans le cas de sollicitation simples comme la traction / compression, la flexion ou la torsion, la contrainte peut être représentée par un scalaire. Par ailleurs, les logiciels de calcul par éléments finis restituent une carte représentant la contrainte équivalente, qui est elle aussi un scalaire. Mais, pour décrire précisément l'état de contrainte, il est préférable d'utiliser une matrice 3x3 ou tenseur.

Les codes de calculs qui peuvent être utilisés pour réaliser l'analyse du comportement mécanique de l'assemblage des parties composantes, et pour obtenir les résultats de la modélisation selon l'invention sont par exemple NASTRAN, ABAQUS, ANSYS (marques déposées).

La figure 2 illustre schématiquement également un dispositif d'accrochage 11 du propulseur latéral (non représenté sur la figure), lequel dispositif d'accrochage est localisé sur la jupe 13 du lanceur spatial 10. La poussée appliquée par la force F du propulseur est transmise localement au corps central via le dispositif d'accrochage 11 fixé à la jupe 13. La jupe est située sous le réservoir 12. En raison de l'application ponctuelle de la poussée F et du fait que le réservoir 12 et la jupe 13 sont reliés l'un à l'autre, le réservoir 12 est soumis à des contraintes locales très importantes. Il faut dès lors, suivant l'art antérieur, renforcer la zone chargée qui se trouve à l'interface entre la jupe 13 et le réservoir 12. Par le fait que le réservoir 12 présente en général une épaisseur constante, c'est l'ensemble du réservoir 12 qui s'en trouve alourdi. Donc, on comprend l'intérêt de répartir le plus possible les flux de la contrainte transmise par la poussée F et transitant à partir de la jupe 13 vers le réservoir 12 pour éviter d'alourdir le lanceur spatial 10. Ainsi, pour répartir le flux on propose, suivant l'invention, d'introduire un organe, dans ce cas l'anneau 9, entre la jupe 13 et le réservoir 12. La figure 2 montre l' insertion, suivant l'invention, de organe 9 dans une zone de modification 6. Dans l'exemple, l'organe 9 est formé par un anneau d'épaisseur variable permettant de répartir le flux de la contrainte transmise par l'application de la poussée F et donc de réduire sa valeur d'une valeur de flux maximale à de préférence une valeur de flux minimale. La répartition du flux peut se comprendre comme l'étalement de l'intégrale du flux le long de l'interface entre la jupe 13 et le réservoir 12.

L'analyse d'un tel problème de contraintes locales dépendant de l'application d'une charge ou force à l'une des parties composantes à assembler et l'analyse de la transmission du flux de contraintes entre les parties composantes se réalise selon des conditions et paramètres prédéterminés de l'assemblage concerné. Par exemple, les contraintes sur l'assemblage peuvent être analysées sous l'effet des efforts de compression, ou sous les effets de traction. Ces analyses se réalisent en bonne pratique au moyen des modèles numériques utilisant des éléments finis pouvant ainsi obtenir des résultats répétables et fiables. Différents ouvrages de référence peuvent être cités comme par exemple « De la CAO au calcul » de Jean-Charles Craveur et Dominique Marceau, Ed. DUNOD ; « A Finite Element Primer », NAFEMS, Ed. E. HINTON ; « Introduction to Nonlinear Finite Element Analysis », NAFEMS, Ed. E. HINTON; « Les règles de calcul des assemblages »,VDI 2230, Verein deutscher, Ed. PI MECA.

Concrètement, il s'agit de modéliser les parties composantes à assembler et leurs conditions limites, et en particulier à l'interface 3 entre les deux parties lorsqu'elles sont assemblées, et d'y simuler l'application de la force F. Ensuite, après avoir lancé une analyse du modèle, on relève comme résultats de l'analyse le flux de contrainte le long de l'interface 3 entre les parties composantes initiale et réceptrice, et les niveaux de contrainte dans la partie réceptrice.

De préférence les parties composantes seront des structures minces dont la dimension géométrique d'épaisseur est typiquement un à trois ordres de grandeurs inférieure aux autres dimensions géométriques. De plus la composante principale de la force F sera de préférence appliquée dans une direction essentiellement perpendiculaire à la direction géométrique de l'épaisseur de la partie composante où elle est appliquée et sans générer de moment important.

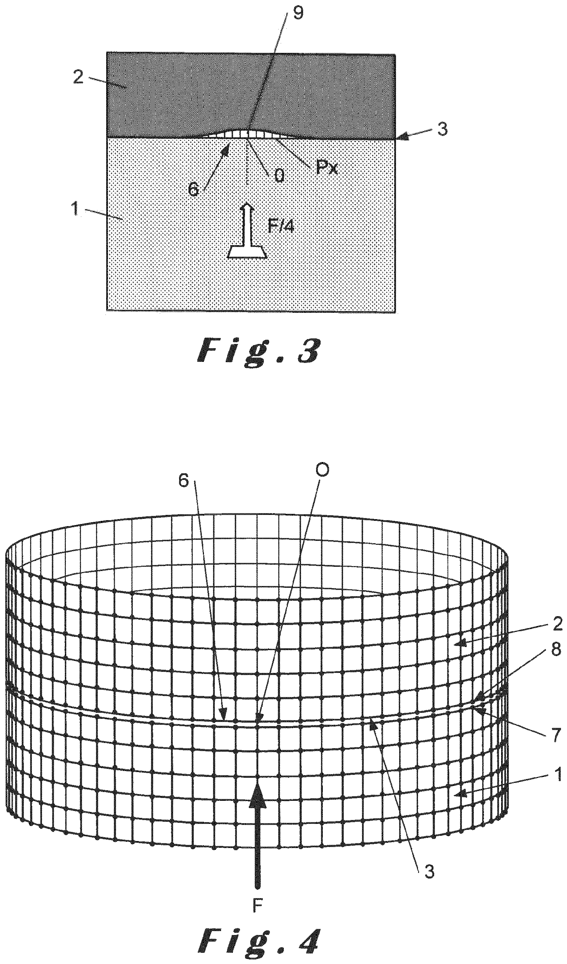

Plus en détail et suivant la méthode revendiquée afin de réaliser cette modélisation, on choisit parmi la première et la deuxième partie composante une partie initiale, par exemple la première partie 1 correspondant à celle où une force F prédéterminée et corrélée à la contrainte devra être appliquée et une partie réceptrice, en l'occurrence la partie 2, qui est l'autre que celle choisie comme partie initiale 1 (voir figure 3). Dans l'exemple des figures 1 et 2, la partie initiale serait formé par la jupe 13 et la partie réceptrice par le réservoir 12.

Ensuite on modélise la partie initiale 1, et au moins une des caractéristiques de raideur de la partie réceptrice, à l'aide d'une modèle numérique par des éléments finis. A la figure 4, la modélisation des deux parties composantes, initiale 1 et réceptrice 2, est représentée à l'état où les parties sont assemblées. La simulation par éléments finis permet donc de représenter l'assemblage des parties composantes 1 et 2 par des lignes et des noeuds 7 et 8. Cette modélisation permet de déterminer le modèle numérique qui comprend la force F et des conditions limites associées aux parties modélisées. Par conditions limites on entend la représentation de l'effet sur la partie modélisée du milieu extérieur à la partie modélisée.

A l'aide de ce modèle on va étudier l'interface 3 entre la partie initiale 1 et la partie réceptrice 2 représentant une surface de contact lorsque ces les parties initiale 1 et réceptrice 2 sont en contact l'une avec l'autre. L'interface 3 est une surface sensiblement perpendiculaire au flux de la contrainte transmise. A la figure 4 cette interface 3 est représentée par une ligne en pointillé séparant la partie initiale 1 de la partie réceptrice 2. Les rangées de noeuds 7 de la partie initiale 1 et les rangées de noeuds 8 de la partie réceptrice 2 au niveau de l'interface 3 sont positionnées en vis-à-vis l'un de l'autre pour en représenter l'interface.

Ensuite, on détermine dans la partie réceptrice 2 une zone critique 10 où la modification de contrainte est recherchée. Après avoir déterminé cette zone critique 10, on identifie dans l'interface 3 une zone de modification 6 où un organe 9 susceptible de modifier le flux de la contrainte transmise dans la zone critique 10 sera introduit. La détermination de cette zone de modification 6 sera dépendante du cas spécifique considéré et de la direction de la force F induite dans le parties ainsi que de leur composition et leur raideur. On détermine dans cette zone de modification 6 une position O d'origine au droit de la position où la force F induisant la contrainte sera appliquée.

Dans l'exemple décrit la zone de modification 6 est plane par rapport au flux. La zone de modification 6 est l'emplacement où physiquement on pourra interposer l'organe 9 qui modifiera la distribution du flux. Par exemple, à la figure 3 on note que cet organe 9 correspond à un anneau d'épaisseur variable. Dans cet exemple l'anneau est modifié sur 30° de part et d'autre à partir de la position O d'origine située au droit de l'application de la force F. On place l'anneau à l'interface 3 dans la zone modification 6 entre la partie initiale 1 et la partie réceptrice 2.

L'organe 9 peut être une pièce intercalaire ou un ensemble de pièces intercalaires. En outre, l'organe 9 peut présenter une épaisseur ou une raideur qui varie sur sa longueur. La variation obtenue par l'organe 9 peut se trouver soit dans l'épaisseur soit dans la raideur de cet organe 9. Les autres paramètres de l'organe 9 étant la hauteur ou la largeur sont définies en fonction du problème spécifique à traiter. Cette variation d'épaisseur est généralement faible, typiquement, elle peut être limitée à une dizaine de millimètres par mètre de longueur de la zone modification 6. Cet organe 9 est donc de préférence mince, par exemple d'épaisseur de deux ordres de grandeur plus petite que la dimension de la composante initiale 1 dans une direction parallèle à celle de la force. Ainsi, dans un assemblage dans lequel les parties composantes ont une dimension en mètres, l'organe peut présenter une épaisseur typique, de 2 à 50, mais plus spécialement 5 à 20 millimètres. Ce qui montre qu'un organe très fin par rapport aux parties composantes peut être utilisé pour une répartition de flux optimale.

Donc, ces organes présenteront une épaisseur ou une raideur permettant d'obtenir la répartition optimisée du flux établi par la méthode décrite. Le meilleur profil de l'organe 9 recherché est celui qui permet de s'approcher le plus des résultats attendus en zone critique 10 de l'analyse réalisée en suivant la méthode selon l'invention.

L'organe 9 est choisi parmi des types prédéterminés d'organes 9 et à chaque type d'organe 9 est associé un type prédéterminé de variables définissant la modification du flux obtenue par l'introduction de l'organe dans la zone de modification. Le type d'organe 9 sera déterminé en fonction de la modification du flux à appliquer. Les types prédéterminés d'organe 9 sont de préférence soit une cale d'épaisseur variable, soit une cale de raideur variable, soit des éléments d'assemblage de raideur variable, soit un jeu. De préférence les variables associées au type d'organe sont soit des variables de raideur, soit des variables de jeu. Les variables associées au type d'organe placé à l'interface sont de préférence représentées dans le modèle numérique par éléments finis qui sont soit des éléments de jeu linéaires, soit des éléments de jeu non-linéaires, soit par des éléments ayant des propriétés d'élasticité individualisés.

Le type d'organe 9 sera déterminé en fonction de la modification du flux à appliquer. Après cela on détermine dans le modèle numérique les couples de noeuds 7 et 8 où seront définies les variables associées au type d'organe 9 déterminé en fonction de la modification du flux à appliquer. Dans la zone de modification 6 on introduira entre chaque couple de noeuds en vis-à-vis un jeu ou une raideur, selon le type d'organe prédéterminé, perpendiculaire au plan de l'interface et dont on considère la valeur comme une des variables. Ceci permet d'introduire le type d'organe 9 choisi ainsi que ces variables dans la zone de modification 6 et en utilisant le modèle numérique. Pour chacun desdits couples de noeuds on détermine ensuite une valeur initiale de la variable associée au type d'organe 9 déterminé pour obtenir un ensemble de variables initiales. Ainsi on initialise une valeur pour le type d'organe 9 choisit, valeur que l'on pourra ensuite faire varier.

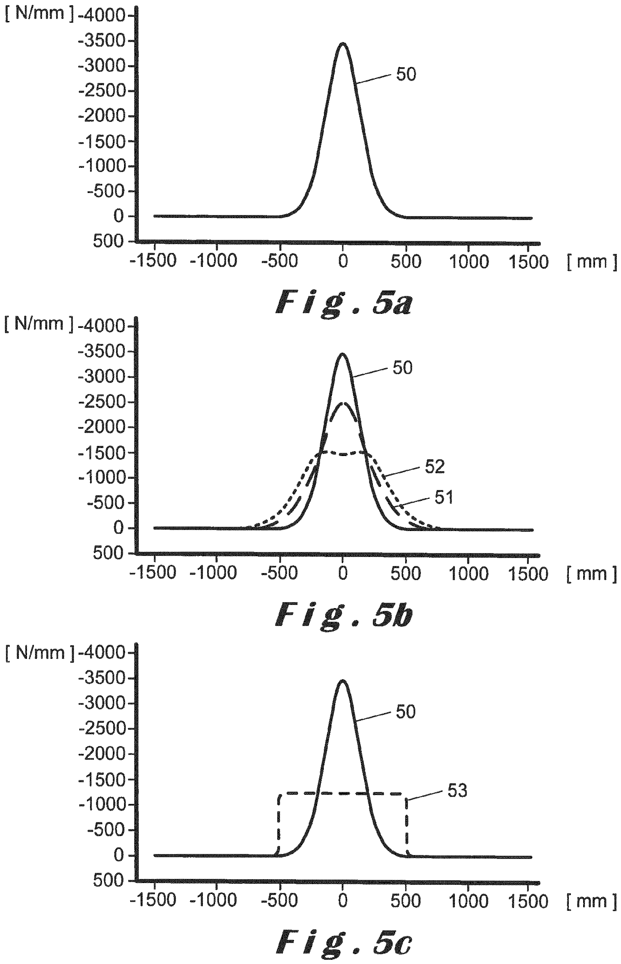

On calcule ensuite, en faisant usage du modèle numérique et de la valeur initiale des variables de l'organe (dans l'exemple décrit, la valeur initiale des jeux introduits est nulle), la valeur maximale initiale de la courbe 50 du flux de la contrainte dans la zone critique 10 située autour du point d'origine O (visible à la figure 5a). A partir de la valeur initiale des variables, on modifie la valeur des variables associées au type d'organe 9 déterminé pour obtenir une valeur subséquente des variables. Ensuite on calcule, en utilisant la valeur subséquente des variables dans le modèle numérique, à nouveau la courbe de flux et on obtient ainsi une valeur maximale subséquente de la courbe du flux dans la zone critique 10, illustré par la courbe de flux 51 visible à la figure 5b. Ceci permet de déterminer la valeur maximale subséquente du flux dans la zone critique 10 en faisant varier la valeur des variables associées au type d'organe 9 choisi.

La valeur maximale subséquente du flux (courbe 51) est ensuite comparée à la valeur maximale initiale de la courbe 50 du flux dans la zone critique 10 pour sélectionner parmi ces valeurs la plus petite des deux. Par itération on modifie alors la valeur subséquente des variables et on calcule, en utilisant chaque fois la valeur subséquente des variables ainsi déterminée la valeur maximale subséquente du flux dans la zone critique 10. La comparaison est répétée à chaque fois pour ainsi obtenir la plus petite valeur maximale du flux. Dans la figure 5b la plus petite valeur maximale du flux est celle illustrée par la courbe 52. L'optimisation consiste en la recherche de la répartition optimale de ces jeux tout le long de l'interface 3. La répartition optimale est celle qui minimise le flux maximum. A partir de la valeur subséquente des variables ayant mené à la plus petite valeur maximale du flux, on détermine ensuite la configuration de l'organe 9 modifiant le flux de contrainte dans la zone critique 10. Il est bien entendu que cette recherche ne se fait pas aléatoirement, mais que la modification des variables se fait en analysant l'effet des changements précédents des variables sur la valeur maximale du flux dans la zone critique 10. De nombreux logiciels (Boss quatro, Optistruc,... (marques déposées) permettent de rechercher de manière automatique cet optimum dans la valeur maximale du flux.

Cette méthode requière toutefois un nombre important de variables qu' il est nécessaire de faire varier en parallèle. Cette approche est possible en utilisant des optimiseurs automatiques, mais est plus difficile en effectuant les modifications l'une après l'autre sans algorithme spécifique. Pour contourner cette exigence, une approche alternative simple est proposée, il s'agit d'identifier un ensemble de valeurs initiales des variables de l'organe 9 et ensuite d'appliquer un facteur de pondération à l'ensemble de ces valeurs. Ceci permet alors de n'avoir plus qu'un seul paramètre à faire varier.

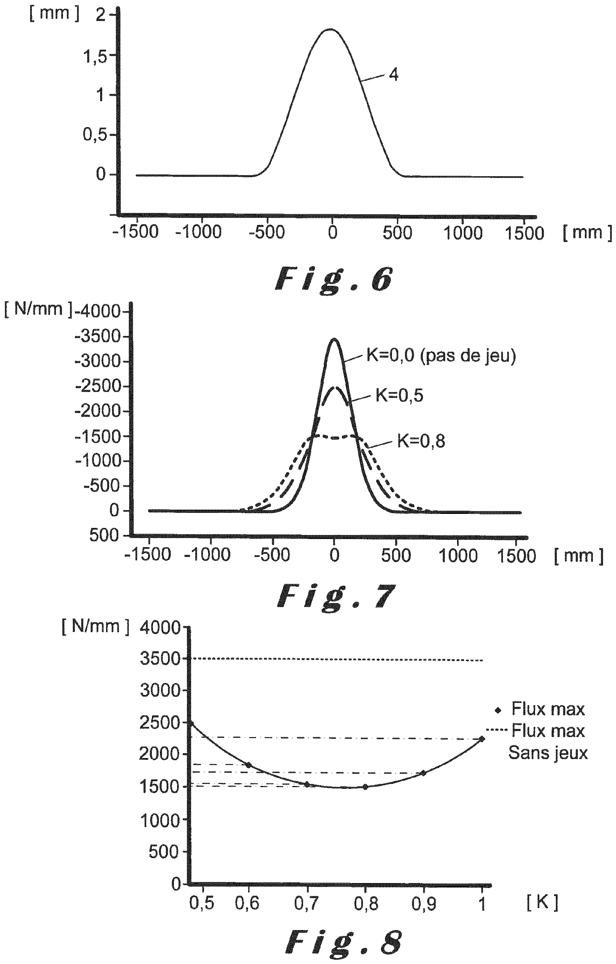

Pratiquement, on procède de la manière suivante : on simule dans le modèle, sans introduire d'organe entre les parties composantes, la force F prédéterminée au droit de la position O d'origine. La force F simulée est celle qui est transmise de la partie initiale 1 à la partie réceptrice 2 (dans l'exemple la jupe 13 au réservoir 12) qui sont en contact l'une avec l'autre. On calcule alors dans la partie critique 10 du modèle (dans l'exemple cette zone est située au niveau de l'interface 3) une première courbe 50 du flux de la contrainte pour la force F en question. On détermine dans cette première courbe 50 sa valeur maximale, qui dans l'exemple repris à la figure 6 est d'environ 3500 N/mm. On identifie ensuite une zone où l'on pourra introduire l'organe, par exemple formé par un jeu susceptible de modifier le flux. Dans l'exemple, la zone de modification 6 utile est formée par l'entièreté de la zone où transite le flux et elle vaut environ 1000 mm.

La courbe 53 illustrée à la figure 5c est la répartition théoriquement optimale du flux sur la zone critique 10. La physique du problème entraîne que l'intégrale sous cette courbe est égale à la valeur de l'effort F, et donc que lors d'une répartition optimale le flux reste constant. Si l'on considère que toute la zone où transite le flux est la zone de modification 10, l'optimum est atteint avec un flux constant tel que représenté à la courbe 53. Une comparaison entre la première de la courbe 50 et la troisième courbe 53 permet de conclure qu'il est possible de répartir le flux sur cette longueur de zone critique et de réduire la valeur maximale du flux. S'agissant toutefois d'une réduction théorique, l'expérience nous permet de conclure qu'en réalité on peut espérer obtenir un flux réparti présentant une valeur de typiquement environ 1.2 fois la valeur du flux idéalement réparti. Donc, dans l'exemple illustré la valeur de correction peut être déterminée à 1.2 x 1 250N/mm, soit 1500 N/mm.

L'obtention de la première de la courbe 50 et de la troisième courbe 53 permet de comparer la valeur du flux réparti idéalement à celle du flux relevé dans le modèle de l'exemple traité, afin d'évaluer l'intérêt de cette répartition du flux par rapport aux critères préalablement établis. Ces critères peuvent être le coût, le risque de rupture, les dimensions des parties composantes,... . Cette comparaison permet aussi de prendre en compte dans le modèle et dans l'analyse la complexité générée par l'introduction de l'organe 9 d'épaisseur variable (comme dans l'exemple décrit au préalable).

Une façon préférentielle pour déterminer un ensemble de valeurs initiales des variables dans le cas où l'organe est formé par des jeux, est de retirer au niveau de l'interface dans le modèle la liaison perpendiculaire entres les parties composantes. On calcule ensuite la déformation des parties composantes sous l'effet de la charge F. On détermine ainsi une courbe 4 d'interpénétration entre la partie initiale 1 et la partie réceptrice 2, comme illustré à la figure 6. Cette courbe 4 d'interpénétration donne pour chaque couple de noeuds de la zone de modification 6 une valeur initiale pour les jeux.

On remet ensuite la liaison perpendiculaire entres les parties composantes à l'interface et on y introduit l'organe en utilisant la valeur initiale pour les jeux (courbe 4) obtenue au préalable. On détermine la courbe de flux en réitérant le calcul et en imposant dans la zone de modification 6 des jeux dont la valeur vaut la valeur initiale des jeux multiplié par un coefficient de pondération kᵢ. On réalise le calcul pour différentes valeur de kᵢ, en particulier pour des valeurs allant de 0, c'est à dire sans jeu, à 1.0, de préférence par pas de 0.1. On obtient, comme illustré à la figure 7, différentes courbes du flux de la contrainte selon chaque fois la valeur kᵢ de pondération choisie. Cette figure montre trois différentes courbes de flux dans une zone critique 10. Ces courbes présentent différentes valeurs de pondération : k₁ = 0.0, k₂ = 0.5, et k₃ = 0.8. La courbe présentant une pondération égale à k₁ = 0.0 est la même courbe que celle obtenue lors de l'exemple repris à la figure 5a et présentant un maximum de flux, à savoir 3500 N/mm dans l'exemple choisi. Dans ce cas, les couples de noeuds 7 et 8 (figure 4) à l'interface 3 ne sont pas affectés par la pondération ce qui veut dire que dans le modèle les deux parties composantes sont bien assemblées, bien en contact, et donc qu'il n'y a pas de jeux. Dans la figure 7, on note aussi deux autres courbes, l'une pour une valeur de pondération égale à k₂ = 0.5 et l'autre pour une pondération égale à k₃ = 0.8. Si on compare ces trois courbes obtenues on note facilement que la meilleure répartition de flux par rapport à la zone de modification 6 est celle qui est obtenue avec une valeur de pondération égale à 0.8, le maximum de la courbe de flux étant dans l'exemple choisi de 1 500 N/mm. Le flux de la contrainte est bien mieux réparti sur la courbe présentant un maximum à 1500 N/mm que sur la courbe présentant un maximum à 3 500 N/mm.

La figure 8 illustre des valeurs de flux maximum pour des valeurs de pondération allant de 0.5 à 1.0. Le but de ce graphique est de permettre la sélection de la valeur de kᵢ de pondération donnant la valeur de flux maximum la plus basse. Dans l'exemple traité cette valeur est la valeur du jeu linéaire optimisé qui est appliqué aux couples de noeuds de l'interface 3 et est égale à 0.8 et donc, 0.8 est le jeu optimisé qui permet la meilleur répartition du flux de la contrainte transmise. La meilleure répartition du flux est généralement obtenue pour une valeur de pondération d'environ 0.80.

La courbe 4 utilisée pour obtenir la valeur initiale des jeux constitueras le point de départ pour déterminer la géométrie de l'organe. On va ainsi multiplier la courbe 4 par le facteur de pondération optimal pour déterminer la géométrie de l'organe 9 à introduire entre les parties composantes afin d'obtenir la meilleur répartition du flux. Ainsi, on pourra usiner l'organe 9 qui sera interposée entre les parties composantes, ceci soit en retirant l'épaisseur correspondante dans une des parties composantes, soit en introduisant entre les parties composantes une pièce intercalaire dont on aura retiré, par usinage, la géométrie de l'organe 9.

La méthode revendiquée permet de répartir les flux de contrainte transmise entre une première composante et un deuxième composante assemblées en modifiant ces parties le moins possible et en y apportant l'organe 9. La pratique démontre que la répartition du flux dans l'assemblage de parties composantes entraine une amélioration du comportement des structures assemblées vis-à-vis du flambement. Ce résultat démontre qu'il est possible de réduire le niveau de contrainte aux endroits les plus critiques. Cela montre également que la méthode constitue, outre un moyen simple et peu coûteux de modification de distribution de flux dans les structures ou assemblages, un outil qui peut contribuer à leur optimisation en tenue ou en masse.

En outre, y a lieu de déterminer si l'assemblage doit être précontraint ou pas, ou partiellement, selon les critères prédéterminés en fonction de l'assemblage à réaliser, comme par exemple la tension dans les éléments de liaison, les contraintes locales autour de ces éléments, le risque de corrosion suite à la tension, le risque de fluage, etc...., et d'acceptabilité du jeu (présence d'une ouverture entre les structures, déformation de la structure en service, déplacement du point d'application de la charge en service,...). En effet, dans de nombreux cas, et en particulier les assemblages boulonnés, il sera possible, en choisissant les vis de fixation et leur serrage, de combler le jeu formé par l'organe, et ainsi de créer dans les parties composantes un champ de contrainte opposé à celui généré par la force qui sera appliquée ultérieurement. Ceci permet d'éviter les discontinuités entre les structures et d'appliquer aux fixations des pré-tensions compatibles avec les bonnes pratiques. Il y a lieu, dans ce cas, de prendre en compte cette précontrainte dans la vérification et l'analyse des structures assemblées et de leurs fixations.

Certains aspects sont à considérer particulièrement. Un cas classique est l'utilisation de couples vis/écrous pour assurer l'assemblage des pièces. Dans ce cas, il est nécessaire de prendre en compte la perte de tension dans les fixations lors de l'application des charges. Il y a lieu de vérifier que dans chacun des cas de charge, l'assemblage n'enfreigne pas les règles de bonne pratique (par exemple une tension insuffisante dans les vis, n'empêchant pas leur dévissage en service). Le cas échéant, le recours à des éléments de rattrapage sera nécessaire, tel que l'utilisation de rondelles Belleville (rondelles ressorts) ou autre éléments de maintien élastiques, ou le recours à des écrous auto-freinés.

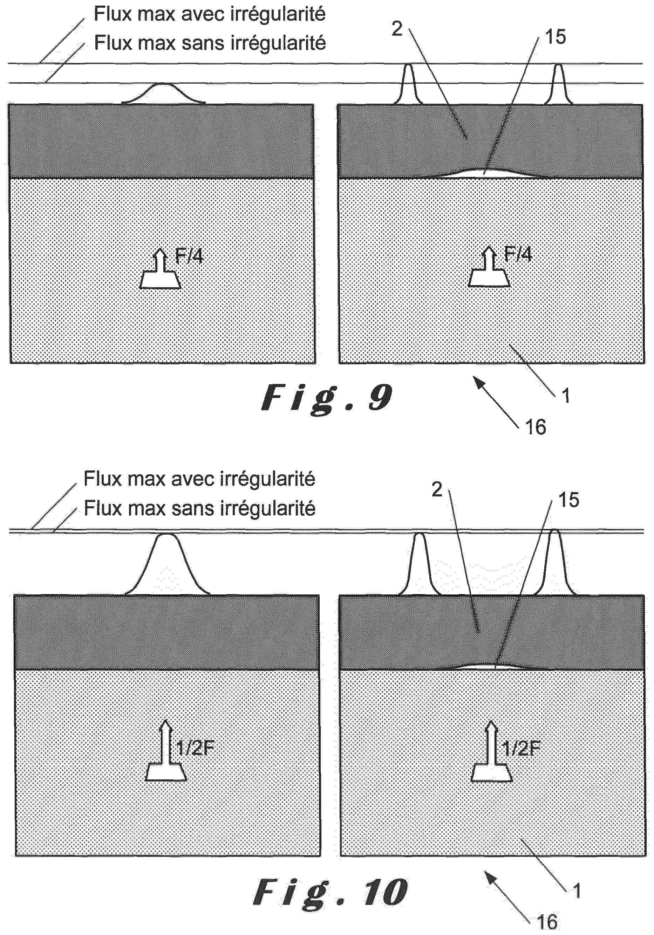

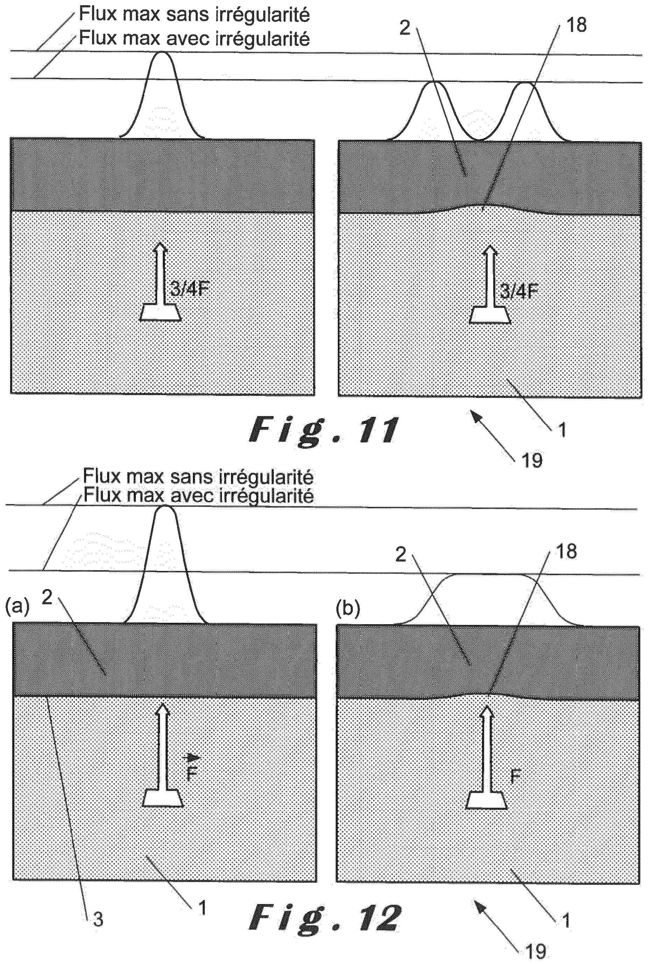

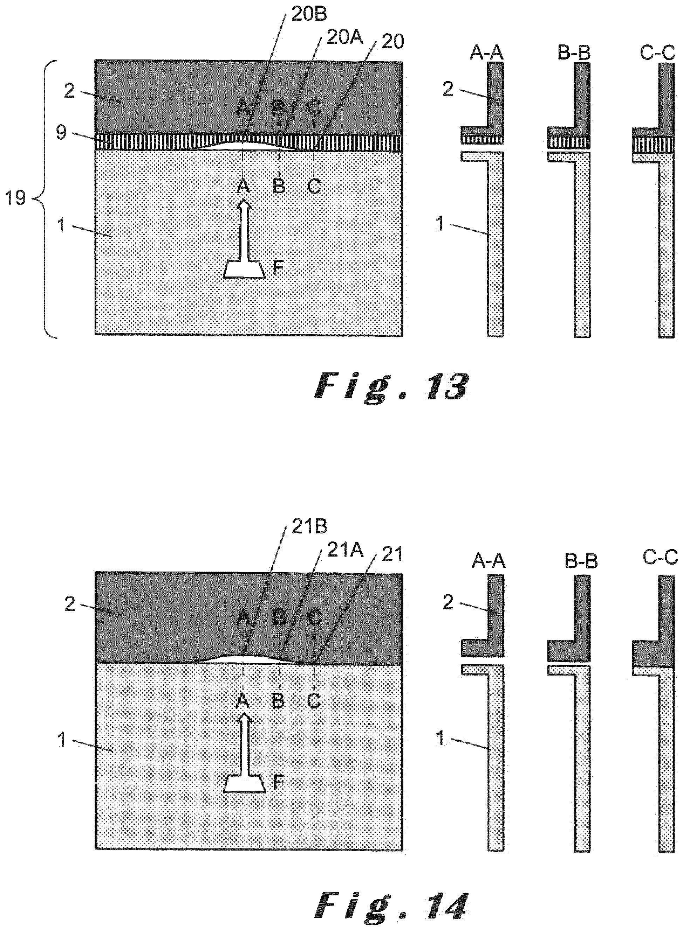

Les figures 9 à 12 illustrent le principe de répartition du flux de manière purement schématique. La figure 12a illustre le flux non répartit lorsque la première 1 et la deuxième 2 composante sont assemblées (sur la figure décrit comme flux maximum sans organe). La figure 12b illustre que lorsqu'un organe 9 (aussi compris comme une irrégularité dans une zone de modification 6 dans l'interface 3) est présent, le flux (décrit comme flux maximum avec organe sur la figure) est plus réparti et l'impact de la force qui est réparti sur les parties composantes assemblées est moins important que dans le cas où l'organe n'est pas présent. On compare, à divers niveaux de chargement (figure 9 : F/4, figure 10 : F/2, figure 11 : 3/4F, et figure 12 la force F critique), les flux de contraintes longitudinales transitant entre deux structures cylindriques, d'épaisseur uniforme, dont l'une est chargée localement. L'ensemble des deux structures formées par les parties composantes est, pour l'exemple, encastré au niveau de face supérieure 6 et libre dans le bas. La figure 13 illustre schématiquement une première 1 et une deuxième 2 composante assemblés l'une à l'autre pour former un assemblage 19.

A l'application d'une charge F faible, la présence d'un jeu entre les deux pièces a naturellement pour effet de séparer en deux portions les parties affectées par le flux. Le principe d'équilibre des forces fait que dans ce contexte, l'intégrale de la courbe de flux d'une contrainte transmise entre une première partie composante et une deuxième partie composante est égale à la force F appliquée. Lorsque l'ensemble des deux parties composantes ne présente pas d'organe 9 (à gauche sur les figures 9 à 12) le flux d'une contrainte transmise entre la première composante et la deuxième composante est simple et affecte une zone limitée de l'interface 3 (effet observé localement). L'introduction d'un jeu de forme sinusoïdale telle que représenté dans la figure de droite sur les figures 9 à 12 réparti en deux zones la courbe de flux, mais sans nécessairement en réduire le maximum comme aux figures 9 et 10. Le jeu ayant pour effet de réduire l'extension de la zone de contact travaillante. Aux figures 11 et 12, on constate qu'en augmentant la force appliquée, le jeu a tendance à se combler, mais en maintenant dans la partie composante 2 un champ de contrainte qui a pour effet de répartir le flux. L"introduction de l'organe 9 entraine ainsi une réduction du flux maximum.

La figure 13 illustre l'interposition d'un organe 9 ou d'un ensemble d'organes d'épaisseur variable entre les parties composantes assemblées non chargées. Les sections A-A, B-B et C-C illustrent la manière dans laquelle l'organe 9 présente une épaisseur variable entre les parties composantes. À la section C-C on note que la partie initiale 1 et la partie réceptrice 2 sont en contact l'une et l'autre avec l'organe 9 sans la présence d'une zone évidée 20. À la section B-B on note que l'organe 9 est totalement en contact avec la partie réceptrice 2 mais qu'une zone 20A légèrement évidée se trouve entre l'organe et la partie initiale 1. Et à la section A-A on note que l'organe 9 est totalement en contact avec la partie réceptrice 2 mais qu'une zone 20B évidée se trouve entre l'organe et la partie initiale 1.

La figure 14 illustre un organe 9 crée directement sur une des faces contigües des parties composantes assemblées non chargées. C'est-à-dire que la partie réceptrice 2 présente un évidement 21B, 21A et 21. À la section C-C on note que les deux parties composantes sont totalement en contact 21 l'une avec l'autre. À la section B-B on note qu'une zone 21A légèrement évidée est présente entre la partie initiale 1 et la partie réceptrice 2. Et à la section A-A on note qu'une zone 21B évidée se trouve entre la partie initiale 1 et la partie réceptrice 2.

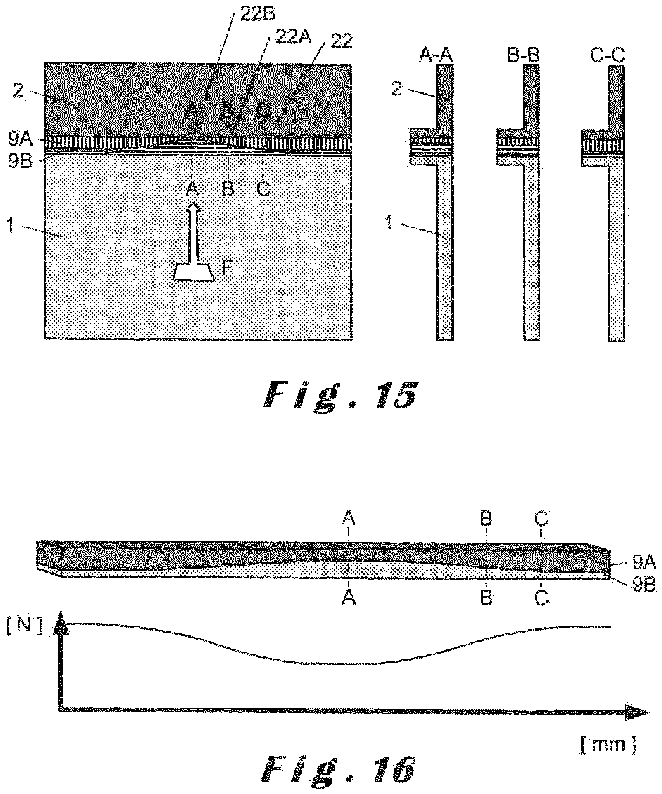

Les figures 15 et 16 illustrent l'interposition de l'organe 9 de raideur variable entre les parties composantes assemblées non chargées : Si l'organe 9 est composé d'une partie 9A faite d'un matériau dont le module élastique est supérieur à celui de la partie 9B, on constate aisément que la section A-A aura une raideur inférieure à celle de la section B-B plus inférieure encore à celle de la section C-C.

Les ensembles présentés aux figures 13 à 15 sont soumis à une force de compression. Ceci étant indiqué aux figures par une flèche pointant vers le haut de la page.

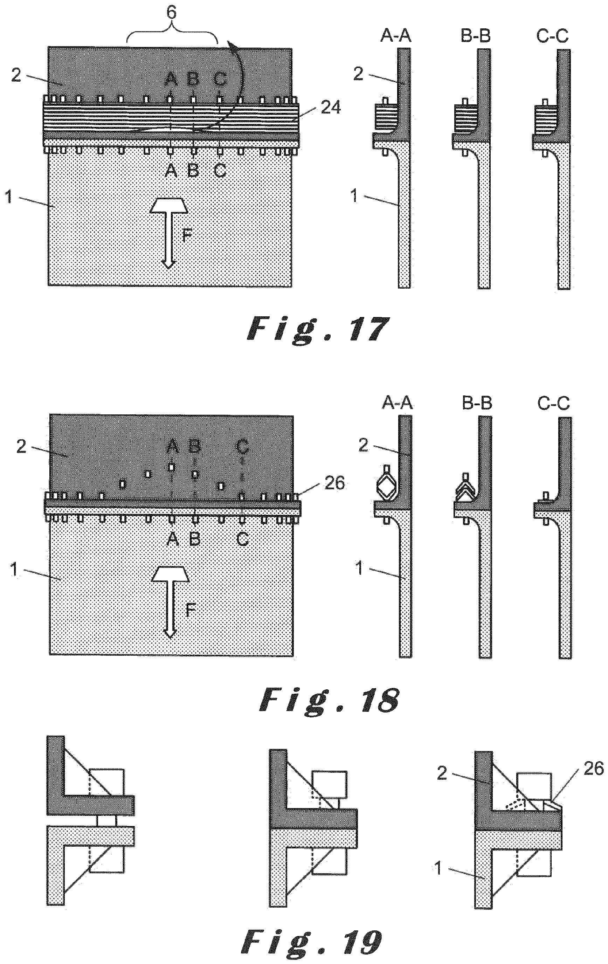

La figure 17 illustre l'assemblage des parties composantes, d'un organe 9 ou d'un ensemble d'organes 9 d'épaisseur variable, et des éléments de fixation, l'assemblage étant non chargé, mais configuré pour être soumis à une force de traction (ceci étant indiqué sur la figure par une flèche pointant vers le bas de la page). À la figure 17 on note également la présence de jeux variant progressivement de la section A-A à la section C-C où le jeu est nul.

La figure 18 illustre l'assemblage des parties composantes, et leurs éléments de fixation, l'assemblage étant non chargé, mais configuré pour être soumis à une force de traction (ceci étant indiqué sur la figure par une flèche pointant vers le bas de la page).

La figure 18 illustre l'assemblage des parties composantes avec des éléments de fixation, en l'occurrence des systèmes écrous vis sous les têtes desquelles on interpose des rondelles ressorts 26 ou des assemblages de rondelles ressorts de raideurs et d'épaisseurs variables, l'assemblage étant soumis à une force de traction. Ces rondelles sont appelées rondelles Belleville et sont utilisées pour permettre de faire varier progressivement la raideur de l'assemblage le long de la zone de modification 6 tout en maintenant une tension dans les fixations une fois les structures chargées. La figure 19 montre que les rondelles Belleville 26 peuvent également être utilisées pour maintenir une pré-tension dans des fixations telles que celles utilisées dans l'exemple de la figure 17. Les sections A-A, B-B et C-C de la figure 18 illustrent différents arrangements des rondelles Belleville, formant des assemblages de plus en plus raides.

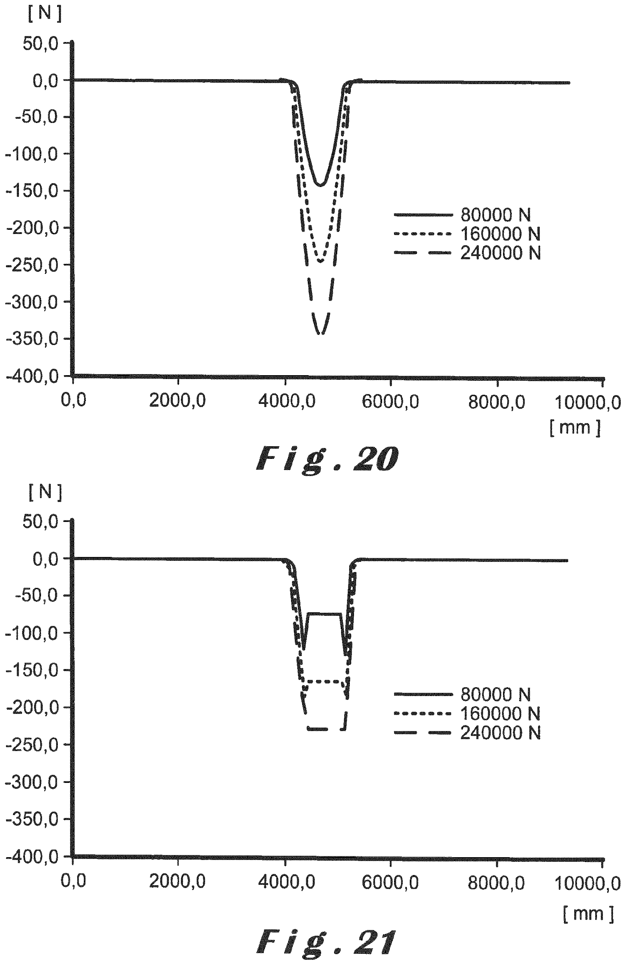

Comme le montre clairement la figure 20, l'augmentation de la force F a pour conséquence, sans la présence d'un organe 9, d'augmenter la valeur du flux dans la zone critique 10. Cette contrainte est locale. Le lien entre la force F et la valeur du flux en un point, ou une zone sensiblement réduite, et donc du flux maximum, est quasiment linéaire. Par contre, dans l'exemple traité, l'introduction d'un jeu adéquat (optimal) a pour effet de modifier sensiblement la forme de la courbe du flux et son extension, et donc aussi d'en modifier le maximum étant bien visible à la figure 21. Ainsi, la courbe montrée à la figure 21 montre clairement une répartition du flux et donc une diminution de la valeur du flux maximum.

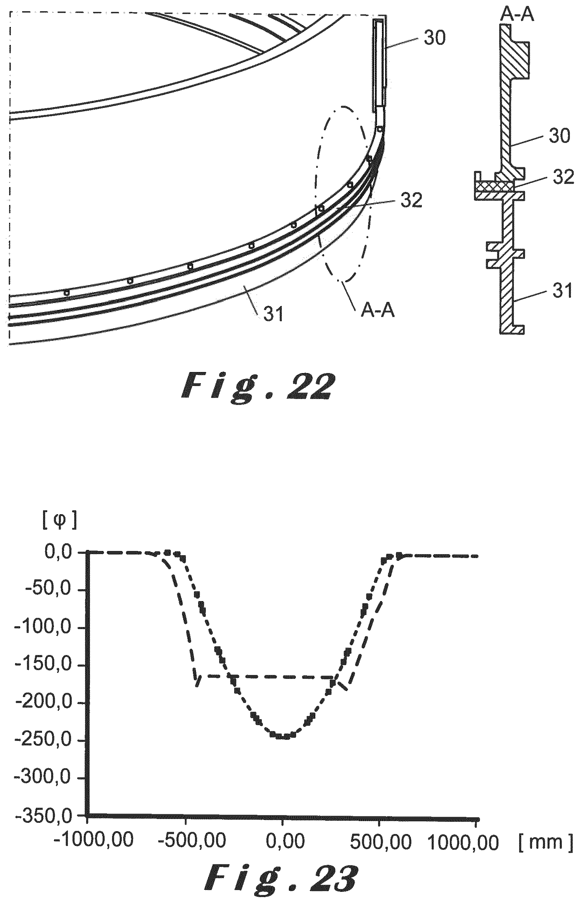

La figure 22 illustre un essai qui a été réalisé sur une structure représentative d'une situation où l'invention est utilisée. Une charge ponctuelle importante est appliquée sur une structure cylindrique 30. Un dispositif 32 de réduction de flux est interposé entre cette première structure 30 et une autre structure 31 (visible sur la figure à la zone A-A). Le flux de contrainte transmise entre la première structure 30 et la deuxième structure 31 est mesuré sur cette seconde structure 31, avec ou sans dispositif 32 de réduction de flux. On comprend par dispositif 32 de réduction de flux un organe 9 où a été usinée l'irrégularité décrite dans le présent document. L'ensemble a été modélisé à l'aide des éléments finis. Pour la configuration réalisée, les essais corroborent parfaitement la modélisation. Le dispositif, non optimisé, permet une réduction du flux maximum de plus de 30%. Le modèle montre que l'optimisation de ce dispositif devrait permettre une réduction du flux maximum de plus de 60%.

La figure 23 montre l'effet mesuré sur le flux par l'application d'un jeu évoluant selon un profil sinusoïdal entre les deux parties de la figure 22.

## Revendications

1. Méthode pour répartir un flux d'une contrainte transmise entre une première partie composante et une deuxième partie composante à assembler, la première et la deuxième partie composante ayant chacune des caractéristiques de raideur prédéterminées, ladite méthode comprenant les étapes de :
- choisir parmi la première et la deuxième partie composante une partie initiale (1) correspondant à celle où une force (F) prédéterminée et corrélée à la contrainte devra être appliquée et une partie réceptrice (2) qui est l'autre que celle choisie comme partie initiale (1) ;
- modéliser la partie initiale (1) et au moins une des caractéristiques de raideur de la partie réceptrice (2) à l'aide d'une simulation numérique par éléments finis et déterminer ainsi un modèle numérique qui comprend la force (F) et les conditions limites associées aux parties modélisées ;
- identifier une interface (3) entre la partie initiale (1) et la partie réceptrice(2), laquelle interface représente une surface de contact lorsque la partie initiale (1) et la partie réceptrice (2) sont en contact l'une avec l'autre; **caractérisé en ce que** la méthode comprend les étapes de;
- déterminer dans soit la partie réceptrice (2), soit la partie initiale (1), soit la partie initiale (1) et la partie réceptrice (2) une zone critique (10) où une modification du flux est recherchée;
- déterminer dans l'interface (3) une zone de modification (6) où un organe (9) susceptible d'obtenir la modification du flux de contrainte dans la zone critique (10) sera introduit et déterminer dans cette zone de modification (6) une position (O) d'origine au droit d'une position où la force (F) induisant la contrainte sera appliquée;
- choisir, en fonction de la modification du flux à appliquer, l'organe parmi des types prédéterminés d'organes;
- déterminer dans le modèle numérique et en fonction de la modification du flux à appliquer, des variables associées au type d'organe (9) déterminé, lesquelles variables définissent les propriétés permettant la modification du flux à appliquer;
- déterminer pour chacune des variables associées au type d'organe (9) déterminé une valeur initiale pour obtenir un ensemble de variables initiales;
- calculer, en faisant usage du modèle numérique, la valeur maximale initiale du flux de la contrainte dans la zone critique (10) ;
- à partir de la valeur initiale des variables, modifier la valeur des variables associées au type d'organe (9) déterminé pour obtenir une valeur subséquente des variables ;
- calculer, en utilisant la valeur subséquente des variables dans le modèle numérique, la valeur maximale subséquente (51) du flux dans la zone critique (10) ;
- comparer la valeur maximale subséquente (51) du flux à la valeur maximale initiale (50) du flux dans la zone critique (10) et sélectionner la plus petite des deux valeurs ;
- par itération, modifier la valeur subséquente des variables et calculer en utilisant chaque fois la valeur subséquente modifiée des variables ainsi déterminée la valeur maximale subséquente du flux dans la zone critique (10), et répéter à chaque fois la comparaison pour ainsi obtenir la plus petite valeur maximale du flux ;
- définir à partir de la valeur subséquente des variables ayant mené à la plus petite valeur maximale du flux l'organe (9) modifiant le flux de contrainte dans la zone critique (10).

2. Méthode pour répartir un flux d'une contrainte transmise entre une première partie composante et une deuxième partie composante à assembler selon la revendication 1, **caractérisée en ce que** les types prédéterminés d'organe (9) sont soit une cale, ou un ensemble de cales, d'épaisseur variable, soit une cale, ou un ensemble de cales, de raideur variable, soit des éléments d'assemblage de raideur variable.

3. Méthode pour répartir un flux d'une contrainte transmise entre une première partie composante et une deuxième partie composante à assembler selon la revendication 1 ou 2, **caractérisée en ce que** les variables associées au type d'organe sont soit des caractéristiques de raideur, soit des caractéristiques de jeu, ou une fonction mathématique décrivant la répartition de ces caractéristiques.

4. Méthode pour répartir un flux d'une contrainte transmise entre une première partie composante et une deuxième partie composante à assembler selon l'une des revendications 1 à 3, **caractérisée en ce que** on modélise en définissant une première géométrie de la première partie composante et une deuxième géométrie de la deuxième partie composante à l'aide d'une simulation numérique par éléments finis, lesquels sont représentés par des lignes, en particulier des bords des parties composantes, et des noeuds.

5. Méthode pour répartir un flux d'une contrainte transmise entre une première partie composante et une deuxième partie composante à assembler selon la revendication 4, **caractérisée en ce que** les variables associées au type d'organe placé à l'interface sont représentées dans le modèle numérique par éléments finis qui sont soit des éléments de jeu linéaires, soit des éléments de jeu non-linéaires, soit par des éléments ayant des propriétés d'élasticité individualisés.

6. Méthode pour répartir un flux d'une contrainte transmise entre une première partie composante et une deuxième partie composante à assembler selon la revendication 5, **caractérisée en ce que** l'on définisse pour l'organe un ensemble de variables initiales et que l'on détermine dans le modèle numérique le flux de contrainte dans la zone critique à l'aide de cet ensemble de variables initiales et en particulier la valeur maximale du flux, et que l'on modifie ensuite l'ensemble des variables pour déterminer le flux de contrainte subséquent dans la zone critique, et que l'on en compare la valeur maximale du flux ainsi obtenu avec la valeur maximale du flux correspondant aux variables initiales, que l'on choisit l'ensemble des variables ayant donné le plus faible valeur maximale du flux, et que l'on réitère cette séquence en analysant l'effet des changements précédents des variables sur la valeur maximale du flux dans la zone critique jusqu'à obtenir une valeur maximale de flux dans la zone critique inférieure à une valeur prédéterminée propre au problème traité.

7. Méthode pour répartir un flux d'une contrainte transmise entre une première partie composante et une deuxième partie composante à assembler selon la revendication 6, **caractérisée en ce que** la modification des variables se fait en ayant recours à des logiciels permettant de rechercher une valeur optimale pour la valeur maximale du flux.

8. Méthode pour répartir un flux d'une contrainte transmise entre une première partie composante et une deuxième partie composante à assembler selon la revendication 4 ou 5, **caractérisée en ce que** l'organe est formé par des jeux, et **en ce que** la détermination de la valeur initiale des variables est réalisée en retirant au niveau de l'interface dans le modèle la liaison sensiblement perpendiculaire entre les parties composantes, ensuite en calculant une déformation des parties composantes sous l'effet de la charge pour obtenir une courbe d'interpénétration (4) entre la partie initiale et la partie réceptrice, la valeur initiale des jeux pour chaque couple de noeud dans la zone de modification étant déterminée à l'aide de ladite courbe d'interpénétration.

9. Méthode pour répartir un flux d'une contrainte transmise entre une première partie composante et une deuxième partie composante à assembler selon la revendication 8, **caractérisée en ce que** l'on réitère la détermination de la courbe de flux en multipliant à chaque fois la valeur initiale par un coefficient de pondération (kᵢ) pour obtenir un ensemble de courbes de flux, l'organe étant déterminé à partir des variables correspondant à la courbe de flux dudit ensemble dont la valeur maximale est la plus faible.

10. Méthode pour répartir un flux d'une contrainte transmise entre une première partie composante et une deuxième partie composante à assembler selon les revendication 9, **caractérisée en ce que** l'on fait varier le coefficient de pondération (kᵢ) entre des valeurs allant de 0 à 1, de préférence par pas de 0,1.

11. Méthode pour répartir un flux d'une contrainte transmise entre une première partie composante et une deuxième partie composante à assembler selon la revendication 10, **caractérisée en ce que** l'organe interposé entre les parties composantes est une cale dont l'épaisseur est localement réduite de la valeur des jeux ayant permis d'obtenir la plus petite valeur maximale de flux dans la zone critique (10), soit que cet organe est réalisé en usinant ces jeux directement dans l'interface d'une des parties composantes.

12. Méthode pour répartir un flux d'une contrainte transmise entre une première partie composante et une deuxième partie composante à assembler selon l'une des revendications 1 à 11, **caractérisée en ce que** l'interface (3) est une surface plane environ perpendiculaire au flux de la contrainte transmise.

13. Méthode pour répartir un flux d'une contrainte transmise entre une première partie composante et une deuxième partie composante à assembler selon l'une des revendications 1 à 12, **caractérisée en ce que** l'organe (9) est formé par une pièce intercalaire ou un ensemble de pièces intercalaires.

14. Méthode pour répartir un flux d'une contrainte transmise entre une première partie composante et une deuxième partie composante à assembler selon la revendication 13, **caractérisée en ce que** l'organe (9) est formé d'une pièce, ou d'un ensemble de pièces, dont l'épaisseur est deux ordres de grandeur plus petite que la dimension des parties à assembler.

15. Méthode pour répartir un flux d'une contrainte transmise entre une première partie composante et une deuxième partie composante à assembler selon la revendication 13 ou 14, **caractérisée en ce que** l'organe (9) présente une épaisseur ou une raideur qui varie sur la longueur de l'organe (9).

16. Méthode pour répartir un flux d'une contrainte transmise entre une première partie composante et une deuxième partie composante à assembler selon la revendication 1 à 12, **caractérisée en ce que** les contraintes considérées à l'interface (3) sont des contraintes de traction, et que l'organe (9) comprend une série d'éléments de fixation dont la raideur varie le long de la zone de modification (6).

17. Méthode pour répartir un flux d'une contrainte transmise entre une première partie composante et une deuxième partie composante à assembler selon l'une des revendications précédentes, **caractérisée en ce qu'**on détermine si la première et la deuxième partie composante doivent être assemblées par précontrainte, et que si tel est le cas une fixation de type prédéterminé est intégrée pour assembler la première et la deuxième partie composante.

18. Méthode pour répartir un flux d'une contrainte transmise entre une première partie composante et une deuxième partie composante à assembler selon l'une des revendications précédentes, **caractérisée en ce que** des éléments d'assemblage entre la première et la deuxième partie composante sont des couples vis/écrous, avec des écrous auto-freinés, et/ou des rondelles Belleville.

19. Méthode pour répartir un flux d'une contrainte transmise entre une première partie composante et une deuxième partie composante à assembler selon l'une des revendications précédentes, **caractérisée en ce que** la contrainte est un effort de compression ou un effort de traction.

## Patentansprüche

1. Verfahren zum Verteilen eines Flusses einer Belastung, die zwischen einem ersten Bestandteil und einem zweiten Bestandteil, die zusammenzufügen sind, übertragen wird, wobei der erste und der zweite Bestandteil jeweils vorbestimmte Steifigkeitseigenschaften aufweisen, wobei das Verfahren die folgenden Schritte aufweist:
- Auswählen aus dem ersten und dem zweiten Bestandteil eines Anfangsteils (1), das jenem entspricht, auf das eine Kraft (F), die vorbestimmt und mit der Belastung korreliert ist, aufgebracht werden soll, und eines Aufnahmeteils (2), welches das anderes als jenes ist, das als Anfangsteil (1) ausgewählt wird;
- Modellieren des Anfangsteils (1) und mindestens einer der Steifigkeitseigenschaften des Aufnahmeteils (2) mittels einer digitalen Simulation durch finite Elemente und somit Bestimmen eines digitalen Modells, das die Kraft (F) und die Grenzbedingungen aufweist, die mit den modellierten Teilen verbunden sind;
- Identifizieren einer Schnittstelle (3) zwischen dem Anfangsteil (1) und dem Aufnahmeteil (2), wobei die Schnittstelle eine Kontaktfläche darstellt, wenn das Anfangsteil (1) und das Aufnahmeteil (2) miteinander in Kontakt sind;
**dadurch gekennzeichnet, dass** das Verfahren die folgenden Schritte aufweist:
- Bestimmen eines kritischen Bereichs (10), in dem eine Änderung des Flusses gesucht wird, entweder in dem Aufnahmeteil (2) oder dem Anfangsteil (1) oder in dem Anfangsteil (1) und dem Aufnahmeteil (2);
- Bestimmen eines Änderungsbereichs (6) in der Schnittstelle (3), wo ein Organ (9), das geeignet ist, die Änderung des Belastungsflusses in dem kritischen Bereich (10) zu erhalten, eingeführt werden soll, und Bestimmen einer Ausgangsposition (O) in diesem Änderungsbereich (6) direkt an einer Position, auf die die Kraft (F) ausgeübt werden soll, die die Belastung bewirkt;
- Auswählen des Organs unter vorbestimmten Organtypen in Abhängigkeit von der anzuwendenden Änderung des Flusses;
- Bestimmen in dem digitalen Modell und in Abhängigkeit von der anzuwendenden Änderung des Flusses von Variablen, die dem bestimmten Organtyp (9) zugeordnet sind, wobei die Variablen die Eigenschaften definieren, die anzuwendende Änderung des Flusses ermöglichen;
- Bestimmen für jede der Variablen, die dem bestimmten Organtyp (9) zugeordnet sind, eines Anfangswerts, um einen Satz von Anfangsvariablen zu erhalten;
- Berechnen des maximalen Anfangswerts des Flusses der Belastung in dem kritischen Bereich (10) unter Verwendung des digitalen Modells;
- ausgehend von dem Anfangswert der Variablen, Ändern der Variablen, die dem bestimmten Organtyp (9) zugeordnet sind, um einen nachfolgenden Wert der Variablen zu erhalten;
- Berechnen des nachfolgenden maximalen Wertes (51) des Flusses in dem kritischen Bereich (10) unter Verwendung des nachfolgenden Werts der Variablen in dem digitalen Modell;
- Vergleichen des nachfolgenden maximalen Wertes (51) des Flusses mit dem maximalen Anfangswert (50) des Flusses in dem kritischen Bereich (10) und Auswählen des kleinsten der zwei Werte;
- Ändern des nachfolgenden Wertes der Variablen durch Iteration und Berechnen des nachfolgenden maximalen Wertes des Flusses in dem kritischen Bereich (10), indem jedes Mal der auf diese Weise geänderte nachfolgende Wert der Variablen verwendet wird, und jedes Mal Wiederholen des Vergleichens, um auf diese Weise den kleinsten maximalen Wert des Flusses zu erhalten;
- Definieren des Organs (9), das den Belastungsfluss in dem kritischen Bereich (10) ändert, ausgehend von dem nachfolgenden Wert der Variablen, der zu dem kleinsten maximalen Wert des Flusses geführt hat.

2. Verfahren zum Verteilen eines Flusses einer Belastung, die zwischen einem ersten Bestandteil und einem zweiten Bestandteil übertragen wird, die zusammenzufügen sind, nach Anspruch 1, **dadurch gekennzeichnet, dass** die vorbestimmten Organtypen (9) entweder ein Keil oder einen Satz von Keilen mit variabler Dicke oder ein Keil oder ein Satz von Keilen mit variabler Steifigkeit oder Verbindungselemente mit variabler Steifigkeit sind.

3. Verfahren zum Verteilen eines Flusses einer Belastung, die zwischen einem ersten Bestandteil und einem zweiten Bestandteil übertragen wird, die zusammenzufügen sind, nach Anspruch 1 oder 2, **dadurch gekennzeichnet, dass** die Variablen, die dem bestimmten Organtyp zugeordnet sind, entweder Steifigkeitseigenschaften oder Spieleigenschaften oder eine mathematische Funktion, die die Verteilung dieser Eigenschaften beschreibt, sind.

4. Verfahren zum Verteilen eines Flusses einer Belastung, die zwischen einem ersten Bestandteil und einem zweiten Bestandteil übertragen wird, die zusammenzufügen sind, nach Anspruch 1 bis 3, **dadurch gekennzeichnet, dass** durch Definieren einer ersten Geometrie des ersten Bestandteils und einer zweiten Geometrie des zweiten Bestandteils mittels einer digitalen Simulation durch finite Elemente, die durch Linien dargestellt werden, insbesondere Ränder der Bestandteile und Knoten modelliert wird.

5. Verfahren zum Verteilen eines Flusses einer Belastung, die zwischen einem ersten Bestandteil und einem zweiten Bestandteil übertragen wird, die zusammenzufügen sind, nach Anspruch 4, **dadurch gekennzeichnet, dass** die Variablen, die dem bestimmten Organtyp zugeordnet sind, das an der Schnittstelle angeordnet wird, in dem digitalen Modell durch finite Elemente, die entweder lineare Spielelemente oder nicht lineare Spielelemente sind, oder durch Elemente dargestellt werden, die individualisierte Elastizitätseigenschaften aufweisen.

6. Verfahren zum Verteilen eines Flusses einer Belastung, die zwischen einem ersten Bestandteil und einem zweiten Bestandteil übertragen wird, die zusammenzufügen sind, nach Anspruch 5, **dadurch gekennzeichnet, dass** für das Organ ein Satz von Anfangsvariablen definiert wird und dass in dem digitalen Modell der Belastungsfluss in dem kritischen Bereich mittels dieses Satzes von Anfangsvariablen und insbesondere der maximale Wert des Flusses bestimmt wird, und dass dann der Satz der Variablen geändert wird, um den nachfolgenden Belastungsfluss in dem kritischen Bereich zu bestimmen, und dass davon der maximale Wert des auf diese Weise erhaltenen Flusses mit dem maximalen Wert des Flusses, der den Anfangsvariablen entspricht, verglichen wird, dass der Satz der Variablen ausgewählt wird, die den geringsten maximalen Wert des Flusses ergeben haben, und dass diese Sequenz durch Analysieren der vorhergehenden Änderungen der Variablen auf den maximalen Wert des Flusses in dem kritischen Bereich bis zum Erhalten eines maximalen Wertes des Flusses in dem kritischen Bereich wiederholt wird, der niedriger als ein vorbestimmter Wert ist, der dem behandelten Problem eigen ist.

7. Verfahren zum Verteilen eines Flusses einer Belastung, die zwischen einem ersten Bestandteil und einem zweiten Bestandteil übertragen wird, die zusammenzufügen sind, nach Anspruch 6, **dadurch gekennzeichnet, dass** das Ändern der Variablen erfolgt, indem Softwares verwendet werden, die ermöglichen, einen optimalen Wert für den maximalen Wert des Flusses zu suchen.

8. Verfahren zum Verteilen eines Flusses einer Belastung, die zwischen einem ersten Bestandteil und einem zweiten Bestandteil übertragen wird, die zusammenzufügen sind, nach Anspruch 4 oder 5, **dadurch gekennzeichnet, dass** das Organ durch Spiele gebildet ist und dass das Bestimmen des Anfangswerts der Variablen durchgeführt wird, indem auf Ebene der Schnittstelle in dem Modell die im Wesentlichen senkrechte Verbindung zwischen den Bestandteilen entfernt wird und indem dann eine Verformung der Bestandteile unter der Einwirkung der Last berechnet wird, um eine Kurve der gegenseitigen Durchdringung (4) zwischen dem Anfangsteil und das Aufnahmeteil zu erhalten, wobei der Anfangswert der Spiele für jedes Paar Konten in dem Änderungsbereich mit Hilfe der Kurve der gegenseitigen Durchdringung bestimmt wird.

9. Verfahren zum Verteilen eines Flusses einer Belastung, die zwischen einem ersten Bestandteil und einem zweiten Bestandteil übertragen wird, die zusammenzufügen sind, nach Anspruch 8, **dadurch gekennzeichnet, dass** das Bestimmen der Kurve des Flusses wiederholt wird, indem jedes Mal der Anfangswert mit einem Gewichtungskoeffizienten (kᵢ) multipliziert wird, um einen Satz von Kurven des Flusses zu erhalten, wobei das Organ ausgehend von den Variablen bestimmt wird, die der Kurve des Flusses des Satzes entsprechen, dessen maximaler Wert der niedrigste ist.

10. Verfahren zum Verteilen eines Flusses einer Belastung, die zwischen einem ersten Bestandteil und einem zweiten Bestandteil übertragen wird, die zusammenzufügen sind, nach Anspruch 9, **dadurch gekennzeichnet, dass** der Gewichtungskoeffizient (kᵢ) zwischen Werten im Bereich von 0 bis 1, vorzugsweise in Schritten von 0,1, geändert wird.

11. Verfahren zum Verteilen eines Flusses einer Belastung, die zwischen einem ersten Bestandteil und einem zweiten Bestandteil übertragen wird, die zusammenzufügen sind, nach Anspruch 10, **dadurch gekennzeichnet, dass** das Organ, das zwischen den Bestandteilen angeordnet ist, ein Keil ist, dessen Dicke um den Wert der Spiele, die ermöglicht haben, den kleinsten maximalen Wert des Flusses in dem kritischen Bereich (10) zu erhalten, örtlich verringert wird, oder dass dieses Organ hergestellt wird, indem diese Spiele direkt in der Schnittstelle von einem der Bestandteile angefertigt werden.

12. Verfahren zum Verteilen eines Flusses einer Belastung, die zwischen einem ersten Bestandteil und einem zweiten Bestandteil übertragen wird, die zusammenzufügen sind, nach einem der Ansprüche 1 bis 11, **dadurch gekennzeichnet, dass** die Schnittstelle (3) eine ebene Fläche ist, die etwa senkrecht zu dem Fluss der übertragenen Belastung ist.

13. Verfahren zum Verteilen eines Flusses einer Belastung, die zwischen einem ersten Bestandteil und einem zweiten Bestandteil übertragen wird, die zusammenzufügen sind, nach einem der Ansprüche 1 bis 12, **dadurch gekennzeichnet, dass** das Organ (9) aus einem Zwischenstück oder ein Satz von Zwischenstücken gebildet ist.

14. Verfahren zum Verteilen eines Flusses einer Belastung, die zwischen einem ersten Bestandteil und einem zweiten Bestandteil übertragen wird, die zusammenzufügen sind, nach Anspruch 13, **dadurch gekennzeichnet, dass** das Organ (9) aus einem Stück oder ein Satz von Stücken gebildet ist, dessen oder deren Dicke um mindestens zwei Größenordnungen kleiner als die Abmessung der Teile ist, die zusammenzufügen sind.

15. Verfahren zum Verteilen eines Flusses einer Belastung, die zwischen einem ersten Bestandteil und einem zweiten Bestandteil übertragen wird, die zusammenzufügen sind, nach Anspruch 13 oder 14, **dadurch gekennzeichnet, dass** das Organ (9) eine Dicke oder eine Steifigkeit aufweist, die über die Länge des Organs (9) variiert.

16. Verfahren zum Verteilen eines Flusses einer Belastung, die zwischen einem ersten Bestandteil und einem zweiten Bestandteil übertragen wird, die zusammenzufügen sind, nach Anspruch 1 bis 12, **dadurch gekennzeichnet, dass** die betreffenden Belastungen an der Schnittstelle (3) Zugbelastungen sind und dass das Organ (9) eine Reihe von Befestigungselementen aufweist, deren Steifigkeit sich entlang des Änderungsbereichs (6) ändert.

17. Verfahren zum Verteilen eines Flusses einer Belastung, die zwischen einem ersten Bestandteil und einem zweiten Bestandteil übertragen wird, die zusammenzufügen sind, nach einem der vorhergehenden Ansprüche, **dadurch gekennzeichnet, dass** bestimmt wird, ob der erste und der zweite Bestandteil durch Vorspannen zusammengefügt werden sollen und, dass, wenn dies der Fall ist, eine Befestigung eines vorbestimmten Typs integriert wird, um den ersten und den zweiten Bestandteil zusammenzufügen.

18. Verfahren zum Verteilen eines Flusses einer Belastung, die zwischen einem ersten Bestandteil und einem zweiten Bestandteil übertragen wird, die zusammenzufügen sind, nach einem der vorhergehenden Ansprüche, **dadurch gekennzeichnet, dass** Verbindungselemente zwischen dem ersten und dem zweiten Bestandteil Schrauben-Muttern-Paare mit selbstsichernden Muttern und/oder Belleville-Scheiben sind.

19. Verfahren zum Verteilen eines Flusses einer Belastung, die zwischen einem ersten Bestandteil und einem zweiten Bestandteil übertragen wird, die zusammenzufügen sind, nach einem der vorhergehenden Ansprüche, **dadurch gekennzeichnet, dass** die Belastung eine Zug- oder Druckspannung ist.

## Claims

1. A method for distributing a flux of a strain transmitted between a first composing portion and a second composing portion to be assembled, the first and second composing portions each having predetermined stiffness characteristics, said method comprising the steps of:
- Selecting among the first and second composing portion an initial portion (1) corresponding to the one where a force (F) predetermined and correlated to the strain will have to be applied and a receiving portion (2) which is the other as the one selected as initial portion (1);
- Modelising the initial portion (1) and at least one of the stiffness characteristics of the receiving portion (2) by means of a digital simulation by finite elements and thus determining a digital model which comprises the force (F) and the limit conditions associated to the modelized portions;
- Identifying an interface (3) between the initial portion (1) and the receiving portion (2), which interface represents a contact surface when the initial portion (1) and the receiving portion (2) are in contact with each other, **characterised in that** the method comprises de steps of;
- Determining in either the receiving portion (2), or the initial portion (1), or the initial portion (1) and the receiving portion (2), a critical zone (10) where a modification of the flux is searched for;
- Determining within the interface (3) a modification zone (6) where a member (9) susceptible of obtaining the strain flux modification in the critical zone (10) will be introduced and determining **in that** modification zone (6) a position (O) of origin perpendicular to a position where the force (F) inducing the strain will be applied;
- Selecting, in function of the flux modification to be applied, the member among predetermined member types;
- Determining in the digital model and in function of the flux modification to be applied, variables associated with the determined type of member (9), which variables define the properties enabling the modification of the flux to be applied;
- Determining for each of the variables associated to the determined type of member (9) an initial value for obtaining a set of initial variables;
- Calculating, by using the digital model, the maximum initial flux value of the strain in the critical zone (10);
- Starting from the initial value of the variables, modifying the value of the variables associated with the determined type of member (9) for obtaining a subsequent value of variables;
- Calculating, by using the subsequent value of variables in the digital model, the maximum subsequent flux value (51) in the critical zone (10);
- Comparing the maximum subsequent flux value (51) with the maximum initial flux value (50) in the critical zone (10) and selecting the smallest of both values;
- By iteration, modifying the subsequent value of the variables and calculating by using each time the subsequent modified value of the variables thus determined the maximum subsequent flux value in the critical zone (10), and repeating each time the comparison in order to thus obtain the smallest maximum value of the flux;
- Defining starting from the subsequent value of the variables having lead to the smallest maximum of the flux, the member (9) modifying the flux of the strain in the critical zone (10).

2. The method for distributing a flux of a strain transmitted between a first composing portion and a second composing portion to be assembled as claimed in claim 1, **characterised in that** the predetermined types of members (9) are either a wedge, or a set of wedges, of variable thickness, or a wedge, or a set of wedges, of variable stiffness , or assembling elements of variable stiffness.

3. The method for distributing a flux of a strain transmitted between a first composing portion and a second composing portion to be assembled as claimed in claim 1 or 2, **characterised in that** the variables associated with the type of members are either stiffness characteristics, or play characteristics, or a mathematical function describing the distribution of these characteristics.

4. The method for distributing a flux of a strain transmitted between a first composing portion and a second composing portion to be assembled as claimed in anyone of the claims 1 to 3, **characterised in that** there is modelized by defining a first geometry of the first composing portion and a second geometry of the second composing portion by means of a digital simulation by finite elements, which are represented by lines, in particular the borders of the composing portions, and knots.

5. The method for distributing a flux of a strain transmitted between a first composing portion and a second composing portion to be assembled as claimed in claim 4, **characterised in that** the variables associated with the type of member placed at the interface are represented in the digital model by finite elements which are either linear play elements, or non-linear play elements, or by elements having individualised elasticity properties.

6. The method for distributing a flux of a strain transmitted between a first composing portion and a second composing portion to be assembled as claimed in claim 5, **characterised in that** there is defined for the member a set of initial variables and that there is determined in the digital model the strain flux in the critical zone by means of this set of initial variables and in particular the maximum value of the flux, and that the set of variables is thereafter modified for determining the subsequent strain flux in the critical zone, and that the maximum flux value thus obtained is compared with the maximum flux value corresponding to the initial values, that the set of variables is selected having given the smallest maximum value for the flux, and that this sequence is re-iterated by analysing the effect of the preceding changes of the variables on the maximum flux value in the critical zone until obtaining a maximum flux value in the critical zone which is lower than a predetermined value which is proper to the treated problem.

7. The method for distributing a flux of a strain transmitted between a first composing portion and a second composing portion to be assembled as claimed in claim 6, **characterised in that** the modification of the variables is realised by using software enabling to search an optimum value for the maximum flux value.

8. The method for distributing a flux of a strain transmitted between a first composing portion and a second composing portion to be assembled as claimed in claim 4 or 5, **characterised in that** the member is formed by play, and **in that** the determination of the initial value of the variables is realised by re-iterating at the level of the interface in the model the substantially perpendicular link between the composing portions, thereafter by calculating a deformation of the composing portions under the effect of the charge for obtaining an interpenetration curve (4) between the initial portion and the receiving portion, the initial value of the play for each couple of knots in the modification zone being determined by means of said interpenetration curve.

9. The method for distributing a flux of a strain transmitted between a first composing portion and a second composing portion to be assembled as claimed in claim 8, **characterised in that** the determination of the flux curve is re-iterated by each time multiplying the initial value by a weighing coefficient (kᵢ) for obtaining a set of flux curves, the member being determined starting from the variables corresponding to the flux curve of said set of which the maximum value is the smallest.

10. The method for distributing a flux of a strain transmitted between a first composing portion and a second composing portion to be assembled as claimed in claim 9, **characterised in that** the weighing coefficient (kᵢ) is varied between values going from 0 to 1, preferably by steps of 0.1.

11. The method for distributing a flux of a strain transmitted between a first composing portion and a second composing portion to be assembled as claimed in claim 10, **characterised in that** the member put between the composing portions is a wedge of which the width is locally reduced with the value of the play having enabled to obtain the smallest maximum flux value in the critical zone (10), or that this member is realised by manufacturing this play directly in the interface of one of the composing portions.

12. The method for distributing a flux of a strain transmitted between a first composing portion and a second composing portion to be assembled as claimed in anyone of the claims 1 to 11, **characterised in that** the interface (3) is a plane surface substantially perpendicular to the flux of the transmitted strain.

13. The method for distributing a flux of a strain transmitted between a first composing portion and a second composing portion to be assembled as claimed in anyone of the claims 1 to 12, **characterised in that** the member (9) is formed by an intercalary piece or a set of intercalary pieces.

14. The method for distributing a flux of a strain transmitted between a first composing portion and a second composing portion to be assembled as claimed in claim 13, **characterised in that** the member (9) is formed by a piece, or a set of pieces, of which the width is twice smaller than the dimension of the portions to be assembled.

15. The method for distributing a flux of a strain transmitted between a first composing portion and a second composing portion to be assembled as claimed in claim 13 or 14, **characterised in that** the member (9) presents a thickness or a stiffness which varies over the length of the member (9).

16. The method for distributing a flux of a strain transmitted between a first composing portion and a second composing portion to be assembled as claimed in anyone of the claims 1 to 12, **characterised in that** the strains considered at the interface (3) are traction strains, and that the member (9) comprises a series of fixing elements of which the stiffness varies along the modification zone (6).

17. The method for distributing a flux of a strain transmitted between a first composing portion and a second composing portion to be assembled as claimed in anyone of the preceding claims, **characterised in that** there is determined if the first and second composing portions have to be assembled by pre-stressing, and if this is the case a fixation of a predetermined type is integrated for assembling the first and second composing portions.

18. The method for distributing a flux of a strain transmitted between a first composing portion and a second composing portion to be assembled as claimed in anyone of the preceding claims, **characterised in that** assembling elements between the first and second portion are couples of screws/ nuts, with auto-braked nuts, and/or Belleville washers.

19. The method for distributing a flux of a strain transmitted between a first composing portion and a second composing portion to be assembled as claimed in anyone of the preceding claims, **characterised in that** the strain is a compression effort or traction effort.
